# EUROPEAN PATENT APPLICATION

(11) **EP 4 109 575 A1**
(43) Date of publication of application: **28.12.2022**
(21) Application number: 22179308.6
(22) Date of filing: 15.06.2022
(51) Int. Cl.: H01L 51/52

(54) **LIGHT EMITTING DEVICE AND DISPLAY DEVICE INCLUDING THE SAME**

(30) Priority: 24.06.2021 KR 20210082546
(71) Applicant: Samsung Display Co., Ltd., Yongin-si, Gyeonggi-do 17113 (KR)
(72) Inventor: HAN, Won Suk, Yongin-si (KR); KANG, Nam Su, Seoul (KR); PARK, Heung Su, Anyang-si (KR); PARK, Hui Ju, Seoul (KR); LEE, Song Eun, Hwaseong-si (KR); LEE, Hyun Shik, Incheon (KR); HWANG, Jae Hoon, Seoul (KR)
(74) Representative: Newcombe, Christopher David

(57) **Abstract**

A light emitting device includes: a first electrode; a second electrode overlapping the first electrode; m light emitting units between the first electrode and the second electrode; and m-1 charge generating layers between adjacent light emitting units, wherein the charge generating layer includes: an n-type charge generating layer and a p-type charge generating layer; at least one of a plurality of n-type charge generating layers includes a dopant including an alkali metal, and at least one of a plurality of n-type charge generating layers includes a dopant including a lanthanum metal; contents of the alkali metal and the lanthanum metal doped in the n-type charge generating layer are different from each other; and the m is a natural number of greater than or equal to 3.

## Description

### CROSS-REFERENCE TO RELATED APPLICATION

The present application claims priority to and the benefit of Korean Patent Application No. 10-2021-0082546 filed in the Korean Intellectual Property Office on June 24, 2021, the entire content of which is incorporated herein by reference.

### BACKGROUND

### 1. Field

Aspects of some embodiments of the present disclosure relate to a light emitting device and a display device including the same.

### 2. Description of the Related Art

A light emitting device is a device having a characteristic in which electrical energy may be converted into light energy. Examples of such a light emitting device include an organic light emitting device using an organic material for a light emitting layer, and a quantum dot light emitting device using a quantum dot for a light emitting layer.

The light emitting device may include a first electrode and a second electrode that overlap each other, and a hole transport region, a light emitting layer, and an electron transport region, which are located between the first electrode and the second electrode. Holes injected from the first electrode move to the light emitting layer through the hole transport region, and electrons injected from the second electrode move to the light emitting layer through the electron transport region. The holes and electrons are combined in the light emitting layer region to generate excitons. Light is generated as the excitons are changed into the ground state from the exited state.

The above information disclosed in this Background section is only for enhancement of understanding of the background and therefore the information discussed in this Background section does not necessarily constitute prior art.

### SUMMARY

Aspects of some embodiments according to the present disclosure include a light emitting device with a relatively reduced leakage current, and a display device including the same and having relatively improved display quality.

Aspects of some embodiments include a light emitting device including: a first electrode; a second electrode overlapping the first electrode; m light emitting units between the first electrode and the second electrode; and m-1 charge generating layers between adjacent light emitting units, wherein the charge generating layer includes: an n-type charge generating layer and a p-type charge generating layer; at least one of a plurality of n-type charge generating layers includes a dopant including an alkali metal, and at least one of a plurality of n-type charge generating layers includes a dopant including a lanthanum metal; contents of the alkali metal and the lanthanum metal doped in the n-type charge generating layer are different from each other; and the m is a natural number of greater than or equal to 3.

According to some embodiments, the alkali metal doped in the n-type charge generating layer may be included in an amount of 0.1 to 3 vol%, and the lanthanum metal doped in the n-type charge generating layer may be included in an amount of 1 to 10 vol%.

According to some embodiments, each of the plurality of n-type charge generating layers may include one type of dopant.

According to some embodiments, at least one of the m light emitting units may emit blue light, and at least one of the remaining light emitting units may emit green light.

According to some embodiments, the m may be 4; the light emitting device may include a first light emitting unit, a second light emitting unit, a third light emitting unit, and a fourth light emitting unit; and the charge generating layer may include a first charge generating layer, a second charge generating layer, and a third charge generating layer.

According to some embodiments, the first charge generating layer may include a (1-n)-th type of charge generating layer, the second charge generating layer may include a (2-n)-th type of charge generating layer, and the third charge generating layer may include a (3-n)-th type of charge generating layer.

According to some embodiments, at least one of the (1-n)-th type of charge generating layer, the (2-n)-th type of charge generating layer, and the (3-n)-th type of charge generating layer may be doped with a dopant including an alkali metal, and at least one of the remaining charge generating layers may be doped with a dopant including a lanthanum metal.

According to some embodiments, one of the (1-n)-th type of charge generating layer, the (2-n)-th type of charge generating layer, and the (3-n)-th type of charge generating layer may be doped with a dopant including a lanthanum metal, and the remainder thereof may be doped with a dopant including an alkali metal.

According to some embodiments, two of the (1-n)-th type of charge generating layer, the (2-n)-th type of charge generating layer, and the (3-n)-th type of charge generating layer may be doped with a dopant including a lanthanum metal, and the remainder thereof may be doped with a dopant including an alkali metal.

According to some embodiments, the n-type charge generating layer may include a host, and the host may include one of compounds represented by Chemical Formula 1 and Chemical Formula 2.

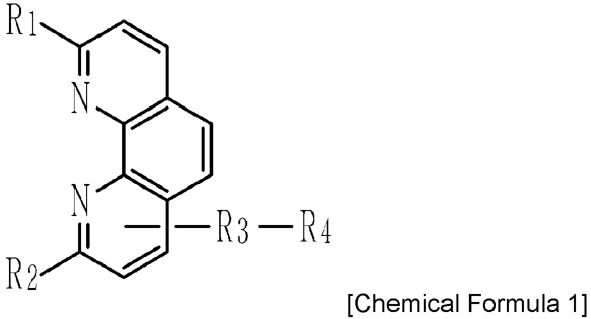

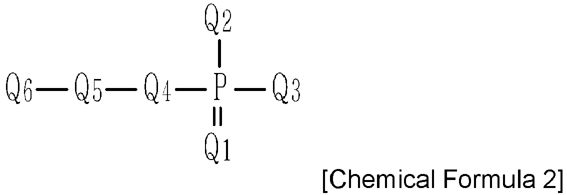

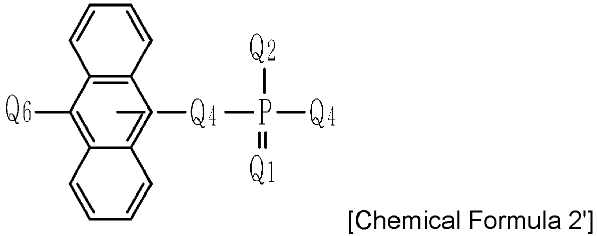

According to some embodiments, the n-type charge generating layer may include one of compounds represented by Chemical Formula 1-A and Chemical Formula 2-A, and in Chemical Formula 1-A and Chemical Formula 2-A, M may be the dopant and forms a complex with the host.

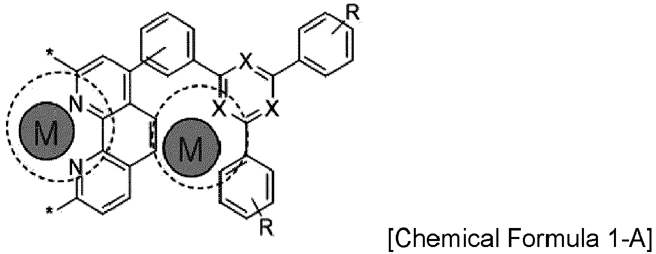

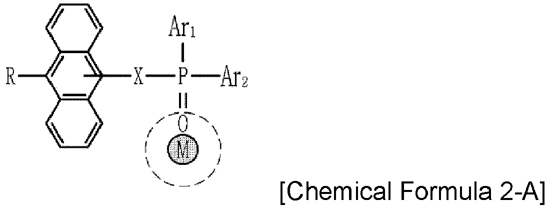

According to some embodiments, a display device includes: a substrate; a transistor on the substrate; and a light emitting device electrically connected to the transistor, wherein the light emitting device includes: a first electrode; a second electrode overlapping the first electrode; m light emitting units between the first electrode and the second electrode; and m-1 charge generating layers between adjacent light emitting units, and the charge generating layer includes: an n-type charge generating layer; at least one of a plurality of n-type charge generating layers includes a dopant including an alkali metal, and at least one of a plurality of n-type charge generating layers includes a dopant including a lanthanum metal, and the m is a natural number of greater than or equal to 3.

According to some embodiments, the display device may further include a color conversion part on the light emitting device, wherein the color conversion part may include a first color conversion layer, a second color conversion layer, and a transmission layer that include quantum dots.

According to some embodiments, the alkali metal may be lithium, and the lanthanum metal may be ytterbium.

According to some embodiments, it may be possible to provide a light emitting device with a relatively reduced leakage current, and a display device with relatively improved display quality.

### BRIEF DESCRIPTION OF THE DRAWINGS

FIG. 1 illustrates a cross-sectional view of a light emitting device according to some embodiments.
FIG. 2 illustrates a cross-sectional view of a light emitting device according to some embodiments.
FIG. 3 illustrates a schematic exploded perspective view of a display device according to some embodiments.
FIG. 4 illustrates a top plan view of a display panel according to some embodiments.
FIG. 5 illustrates a schematic cross-sectional view of a display panel according to some embodiments.
FIG. 6 illustrates a cross-sectional view of a display panel according to some embodiments.
FIG. 7A, FIG. 7B, and FIG. 7C illustrate circuit diagrams associated with leakage currents for Example 1, Example 2, and Example 3, respectively, and FIG. 7D and FIG. 7E illustrate circuit diagrams associated with leakage currents for Comparative Example 1 and Comparative Example 2, respectively.
FIG. 8 illustrates a schematic view of a leakage current of a display panel according to some embodiments.
FIG. 9A illustrates a light emitting image according to some embodiments, and FIG. 9B illustrates a light emitting image according to a comparative example.
FIG. 10 illustrates a graph of a color displacement characteristic according to a gray.

### DETAILED DESCRIPTION

Aspects of some embodiments of the present invention will be described more fully hereinafter with reference to the accompanying drawings, in which aspects of some embodiments of the invention are shown. As those skilled in the art would realize, the described embodiments may be modified in various different ways, all without departing from the spirit or scope of embodiments according to the present invention.

In order to more clearly describe embodiments according to the present invention, description of some parts or aspects that is not necessary to describe in order to enable a person having ordinary skill in the art to make and use embodiments according to the present disclosure may be omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, area or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly described to the contrary, the word "comprise" and variations such as "comprises" or "comprising" will be understood to imply the inclusion of stated elements, but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

The expression "(an interlayer) includes at least one compound represented by Formula 1" as used herein may include a case in which "(an interlayer) includes one or more identical compounds represented by Formula 1" and a case in which "(an interlayer) includes two or more different compounds represented by Formula 1".

The term "group" as used herein refers to a group of the IUPAC periodic table of the elements.

The term "alkali metal" as used herein refers to group 1 elements. For example, the alkali metal may be lithium (Li), sodium (Na), potassium (K), rubidium (Rb), or cesium (Cs).

The term "alkaline earth metal" as used herein refers to group 2 elements. For example, the alkaline earth metal may be magnesium (Mg), calcium (Ca), strontium (Sr), or barium (Ba).

The term "lanthanum metal" as used herein refers to lanthanum and lanthanide elements in the periodic table. For example, the lanthanum metal may be lanthanum (La), cerium (Ce), praseodymium (Pr), neodymium Nd, promethium (Pm), samarium (Sm), europium (Eu), gadolinium (Gd), terbium (Tb), dysprosium (Dy), holmium (Ho), erbium (Er), thulium (Tm), ytterbium (Yb), or ruthenium (Ru).

The term "transition metal" as used herein refers to elements that belong to periods 4 to 7 and groups 3 to 12. For example, the transition metal may be titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), zinc (Zn), or cadmium (Cd).

The term "late transition metal" as used herein refers to metal elements that belong to one of period 4 to period 7 and simultaneously belong to one of group 13 to group 17. For example, the late transition metal may be aluminum (Al), gallium (Ga), indium (In), thallium (TI), tin (Sn), lead (Pb), bismuth (Bi), or polonium (Po).

The term "halogen" as used herein refers to group 17 elements. For example, the halogen may be fluorine (F), chlorine (CI), bromine (Br), or iodine (I).

The term "inorganic semiconductor compound" as used herein may refer to all compounds being an inorganic material and having a band gap of less than 4 eV. For example, the inorganic semiconductor compound may include a halide of a lanthanide metal, a halide of a transition metal, a halide of a late transition metal, tellurium, a telluride of a lanthanide metal, a telluride of a transition metal, a telluride of a late transition metal, a selenide of a lanthanide metal, a selenide of a transition metal, a selenide of a late transition metal, or any combination thereof. For example, the inorganic semiconductor compound may include EuI₂, YbI₂, SmI₂, TmI₂, Agl, Cul, NiI₂, CoI₂, BiI₃, PbI₂, SnI₂, Te, EuTe, YbTe, SmTe, TmTe, EuSe, YbSe, SmSe, TmSe, ZnTe, CoTe, ZnSe, CoSe, Bi₂Te₃, Bi₂Se₃, or any combination thereof.

The term "inorganic insulation compound" as used herein may refer to all compounds being an inorganic material and having a band gap of at least 4 eV. For example, the inorganic insulation compound may include a halide of an alkali metal, a halide of an alkaline earth metal, a halide of a lanthanide metal, or any combination thereof. For example, the inorganic insulation compound may include Nal, KI, RbI, Csl, NaCl, KCl, RbCl, CsCl, NaF, KF, RbF, CsF, MgI₂, CaI₂, SrI₂, BaI₂, MgCI2, CaCI2, SrCl₂, BaCl₂, MgF₂, CaF₂, SrF₂, BaF₂, EuI₃, YbI₃, SmI₃, TmI₃, EuCl₃, YbCl₃, SmCl₃, TmCl₃, EuF₃, YbF₃, SmF₃, TmF₃, or any combination thereof.

The term "halide of an alkali metal" as used herein refers to a compound in which an alkali metal and a halogen are ionically bonded. For example, the halide of the alkali metal may include Nal, Kl, RbI, Csl, NaCl, KCI, RbCI, CsCI, NaF, KF, RbF, CsF, or any combination thereof.

The term "halide of an alkaline earth metal" as used herein refers to a compound in which an alkaline earth metal and a halogen are ionically bonded. For example, the halide of the alkaline earth metal may include MgI₂, CaI₂, SrI₂, BaI₂, MgCl₂, CaCl₂, SrCl₂, BaCl₂, MgF₂, CaF₂, SrF₂, BaF₂, or any combination thereof.

The term "halide of a lanthanide metal" as used herein refers to a compound in which a lanthanide metal and a halogen are ionically bonded and/or covalently bonded. For example, the halide of the lanthanide metal may include EuI₂, YbI₂, SmI₂, TmI₂, EuI₃, YbI₃, SmI₃, TmI₃, EuCl₃, YbCl₃, SmCl₃, TmCl₃, EuF₃, YbF₃, SmF₃, TmF₃, or any combination thereof.

The term "halide of a transition metal" as used herein refers to a compound in which a transition metal and a halogen are ionically bonded and/or covalently bonded. For example, the halide of the transition metal may include Agl, Cul, NiI₂, CoI₂, or any combination thereof.

The term "halide of a late transition metal" as used herein refers to a compound in which a late transition metal and a halogen are ionically bonded and/or covalently bonded. For example, the halide of the late transition metal may include BiI₃, PbI₂, SnI₂, or any combination thereof.

The term "telluride of a lanthanide metal" as used herein refers to a compound in which a lanthanide metal and tellurium (Te) are ionically bonded, covalently bonded, and/or metallically bonded. For example, the telluride of the lanthanide metal may include EuTe, YbTe, SmTe, TmTe, or any combination thereof.

The term "telluride of a transition metal" as used herein refers to a compound in which a transition metal and tellurium are ionically bonded, covalently bonded, and/or metallically bonded. For example, the telluride of the transition metal may include ZnTe, CoTe, or any combination thereof.

The term "telluride of a late transition metal" as used herein refers to a compound in which a late transition metal and tellurium are ionically bonded, covalently bonded, and/or metallically bonded. For example, the telluride of the late transition metal may include Bi₂Te₃.

The term "selenide of a lanthanide metal" as used herein refers to a compound in which a lanthanide metal and selenium (Se) are ionically bonded, covalently bonded, and/or metallically bonded. For example, the selenide of the lanthanide metal may include EuSe, YbSe, SmSe, TmSe, or any combination thereof.

The term "selenide of a transition metal" as used herein refers to a compound in which a transition metal and selenium are ionically bonded, covalently bonded, and/or metallically bonded. For example, the selenide of the transition metal may include ZnSe, CoSe, or any combination thereof.

The term "selenide of a late transition metal" as used herein refers to a compound in which a late transition metal and selenium are ionically bonded, covalently bonded, and/or metallically bonded. For example, the selenide of the late transition metal may include Bi₂Se₃.

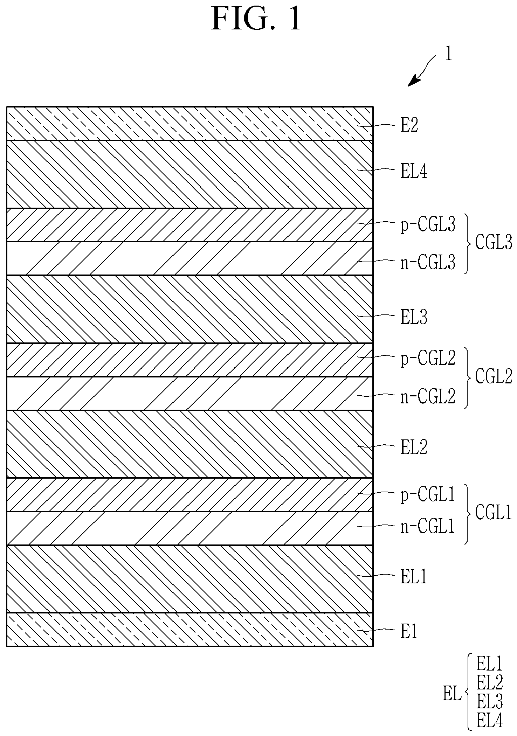

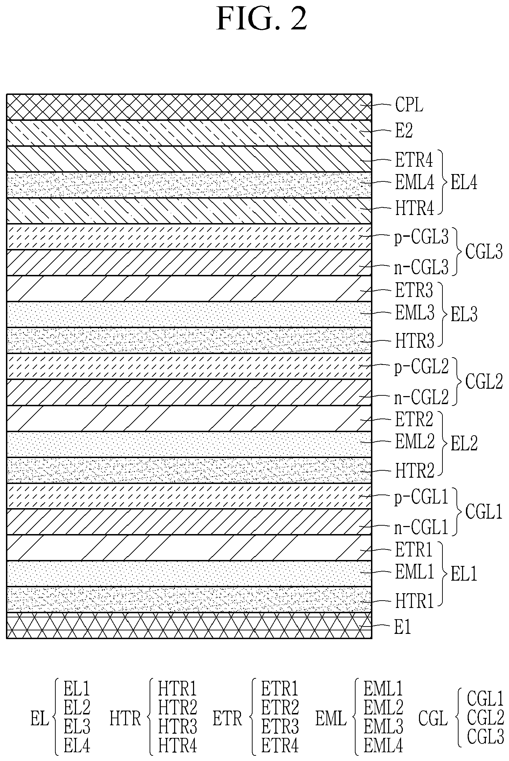

Hereinafter, a light emitting device according to some embodiments will be described with reference to FIG. 1 and FIG. 2. FIG. 1 illustrates a cross-sectional view of a light emitting device according to some embodiments, and FIG. 2 illustrates a cross-sectional view of a light emitting device according to some embodiments.

First, referring to FIG. 1, a light emitting device 1 may include a first electrode E1, a second electrode E2, and a plurality of light emitting units EL located between the first electrode E1 and the second electrode E2.

The light emitting device 1 according to some embodiments of the present invention may be a top emission type of. In this case, the first electrode E1 may be an anode, and the second electrode E2 may be a cathode. The light emitting device 1 according to some embodiments of the present invention may be a bottom emission light emitting device. In this case, the first electrode E1 may be a cathode, and the second electrode E2 may be an anode. In the light emitting device 1 according to some embodiments of the present invention, the first electrode E1 is a reflective electrode, and the second electrode E2 is a transmissive or transflective electrode, so the light emitting device 1 emits light from the first electrode E1 toward the second electrode E2. Hereinafter, a case in which the light emitting device is a top emission type of will be described.

The first electrode E1 may be formed, for example, by providing a material for the first electrode on the substrate by using a deposition method or a sputtering method. When the first electrode E1 is an anode, a material for the first electrode may be selected from materials having a high work function to facilitate hole injection.

The first electrode E1 may be a reflective electrode, a transflective electrode, or a transmissive electrode. In order to form the first electrode E1, which is a transmissive electrode, the material for the first electrode may be selected from an indium tin oxide (ITO), an indium zinc oxide (IZO), a tin oxide (SnO₂), a zinc oxide (ZnO), and a combination thereof, but is not limited thereto. Alternatively, in order to form the first electrode E1, which is a transflective electrode or a reflective electrode, the material for the first electrode may be selected from magnesium (Mg), silver (Ag), aluminum (Al), aluminum-lithium (Al-Li), calcium (Ca), magnesium-indium (Mg-In), magnesium-silver (Mg-Ag), and a combination thereof, but embodiments according to the present disclosure are not limited thereto.

The first electrode E1 may have a single-layered structure having a single layer, or a multi-layered structure having a plurality of layers. For example, the first electrode E1 may have a three-layered structure of ITO/Ag/ITO, but embodiments according to the present disclosure are not limited thereto.

m light emitting units EL are located on the first electrode E1. According to some embodiments, m may be a natural number of 3 or more. The light emitting element 1 according to some embodiments may include at least three or more light emitting units EL.

Among the m light emitting units EL, the light emitting unit closest to the first electrode E1 is referred to as a first light emitting unit, the light emitting unit furthest to the first electrode E1 is referred to as an m-th light emitting unit, and the first light emitting unit to the m-th light emitting unit are sequentially arranged. In the present specification, the embodiments in which four light emitting units are utilized is described, but embodiments according to the present invention are not limited to numbers of the light emitting units. The embodiments according to the present specification may include a first light emitting unit EL1, a second light emitting unit EL2, a third light emitting unit EL3, and a fourth light emitting unit EL4 that are arranged in order adjacent to the first electrode E1.

The light emitting device 1 according to some embodiments includes charge generating layers CGL1, CGL2, and CGL3 located between adjacent light emitting units EL. The charge generating layers CGL1, CGL2, and CGL3 may generate charges (electrons and holes) by forming a complex through an oxidation-reduction reaction when a voltage is applied thereto. The charge generating layers CGL1, CGL2, and CGL3 may provide the generated charges to the light emitting units EL adjacent thereto. The charge generating layers CGL1, CGL2, and CGL3 may double efficiency of a current generated in the light emitting unit EL, and may serve to adjust balance of charges between the adjacent light emitting units EL.

When the light emitting device 1 includes m light emitting units EL, the light emitting device 1 may include m-1 charge generating layers CGL1, CGL2, and CGL3 interposed between adjacent light emitting units EL. The light emitting device 1 according to some embodiments may include the first charge generating layer CGL1 located between the first light emitting unit EL1 and the second light emitting unit EL2, the second charge generating layer CGL2 located between the second light emitting unit EL2 and the third light emitting unit EL3, and the third charge generating layer CGL3 located between the third light emitting unit EL3 and the fourth light emitting unit EL4. Although the present specification shows example embodiments including three charge generating layers CGL1, CGL2, and CGL3, embodiments according to the present disclosure are not limited thereto, and they may vary depending on the number of light emitting units EL.

Each of the charge generating layers CGL1, CGL2, and CGL3 may include n-type charge generating layers n-CGL1, n-CGL2, and n-CGL3 that provide electrons to the light emitting unit EL and p-type charge generating layers p-CGL1, p-CGL2, and p-CGL3 that provide holes to the light emitting unit EL. According to some embodiments, a buffer layer may be further located between each of the n-type charge generating layers n-CGL1, n-CGL2, and n-CGL3 and each of the p-type charge generating layers p-CGL1, p-CGL2, and p-CGL3.

The first charge generating layer CGL1 includes a (1-n)-th type of charge generating layer n-CGL1 and a (1-p)-th type of charge generating layer p-CGL1. The (1-n)-th type of charge generating layer n-CGL1 may be located adjacent to the first light emitting unit EL1, and the (1-p)-th type of charge generating layer p-CGL1 may be located adjacent to the second light emitting unit EL2. The second charge generating layer CGL2 includes a (2-n)-th type of charge generating layer n-CGL2 and a (2-p)-th type of charge generating layer p-CGL2. The (2-n)-th type of charge generating layer n-CGL2 may be located adjacent to the second light emitting unit EL2, and the (2-p)-th type of charge generating layer p-CGL2 may be located adjacent to the third light emitting unit EL3. The third charge generating layer CGL3 includes a (3-n)-th type of charge generating layer n-CGL3 and a (3-p)-th type of charge generating layer p-CGL3. The (3-n)-th type of charge generating layer n-CGL3 may be located adjacent to the third light emitting unit EL3, and the (3-p)-th type of charge generating layer p-CGL3 may be located adjacent to the fourth light emitting unit EL4.

According to some embodiments, the n-type charge generating layers n-CGL1, n-CGL2, and n-CGL3 may include a host and a dopant doped therein. The host may include at least one of a phosphine oxide-based compound or a phenanthroline-based compound. The dopant may include an alkali metal or a lanthanum metal.

The phenanthroline-based compound may be represented by Chemical Formula 1 below, and for example, may include compounds represented by Chemical Formula 1-1 to Chemical Formula 1-7. 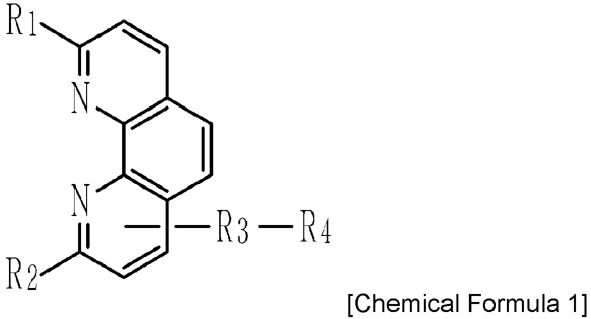 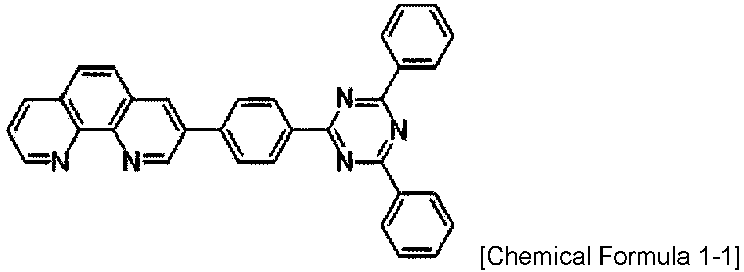 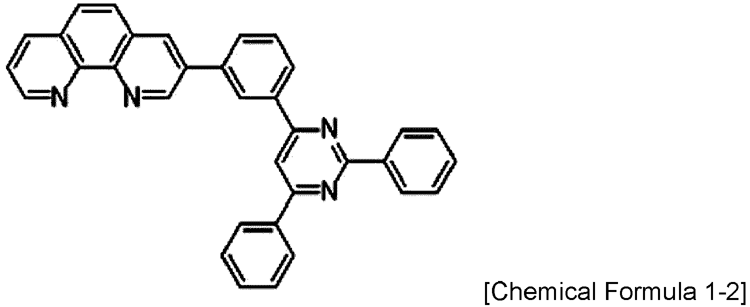 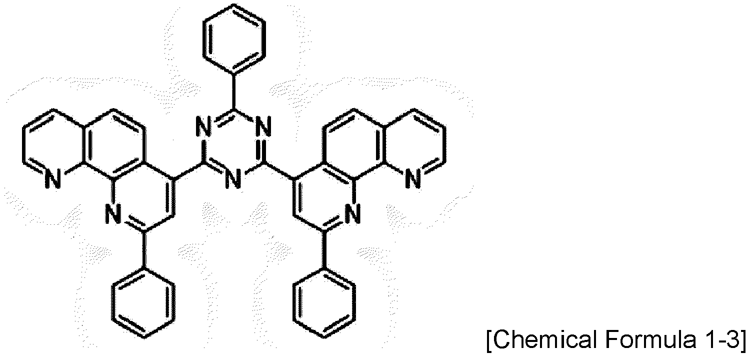 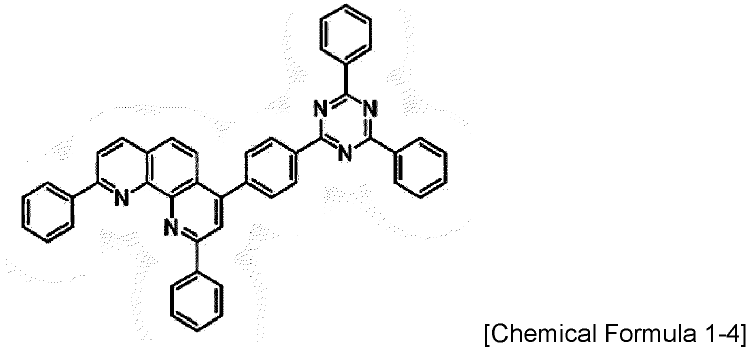 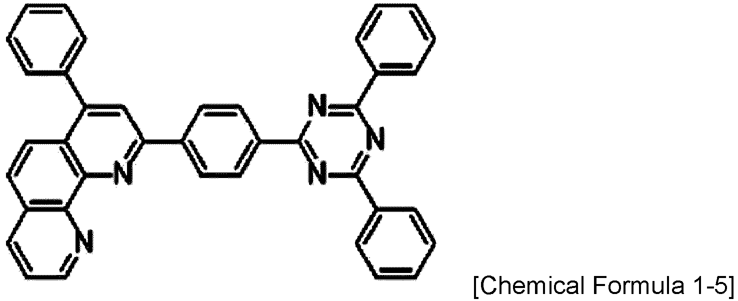 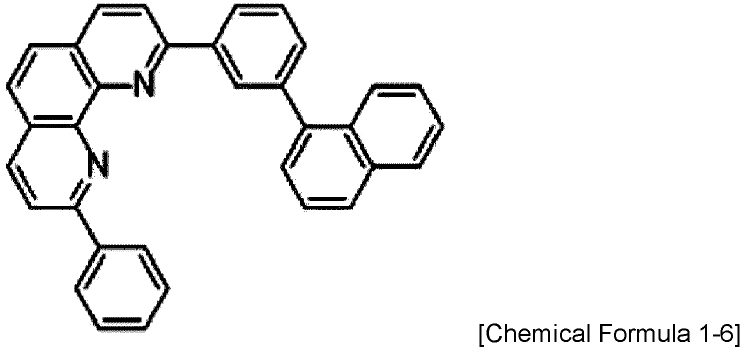 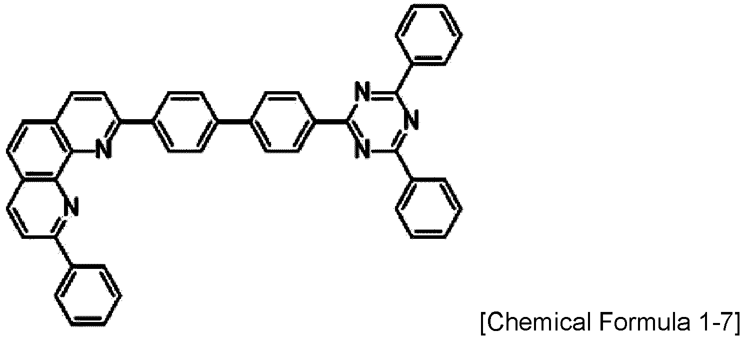
each of R1, R2, R3, R4, R5, and R6 independently includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, a substituted or unsubstituted heteroaryl group having 2 or more to 30 or less ring-formed carbon atoms, a substituted or unsubstituted phenanthroline group, 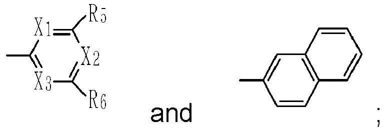 ; and
each of X1, X2, and X3 independently includes one of a carbon atom, a nitrogen atom, and an oxygen atom. The phosphine oxide-based compound may be represented by Chemical Formula 2 or Chemical Formula 2' below, and for example, may include compounds represented by Chemical Formula 2-1 to Chemical Formula 2-17.

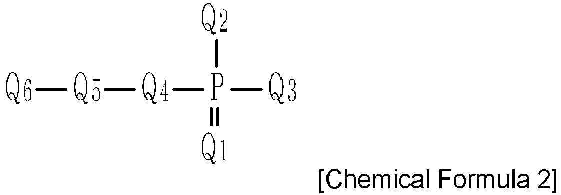

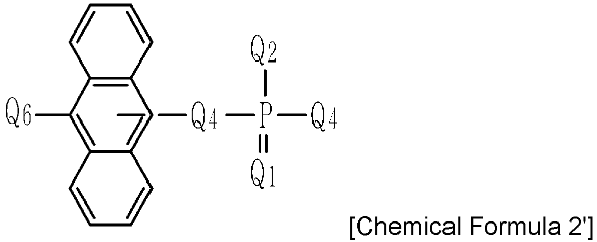

In Chemical Formula 2 and Chemical Formula 2',
Q1 includes one of an oxygen atom and a sulfur atom;
each of Q2, Q3, Q4, and Q5 independently includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, and a substituted or unsubstituted heteroaryl group having 2 or more to 30 or less ring-formed carbon atoms;
Q6 independently includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, and a substituted or unsubstituted heteroaryl group having 2 or more to 30 or less ring-formed carbon atoms, , 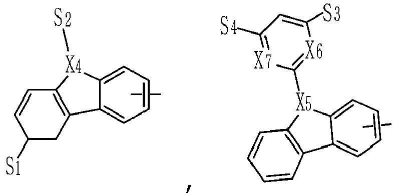 , and 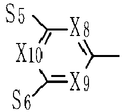 ,
S1 includes at least one of a CN, a hydrogen atom, a deuterium atom, a halogen atom, a substituted or unsubstituted amino group, a substituted or unsubstituted oxy group, a substituted or unsubstituted thio group, and a substituted or unsubstituted alkyl group having 1 or more to 20 or less carbon atoms;
S2, S3, S4, S5, or S6 includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, and a substituted or unsubstituted heteroaryl group having 2 or more to 30 or less ring-formed carbon atoms; and
each of X4, X5, X6, X7, X8, X9, and X10 independently includes one of a carbon atom, a nitrogen atom, and an oxygen atom.

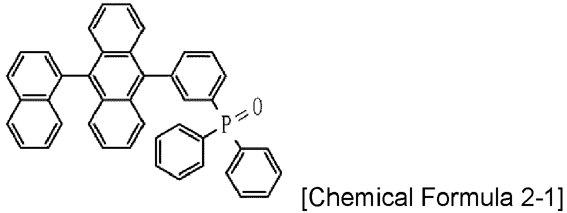

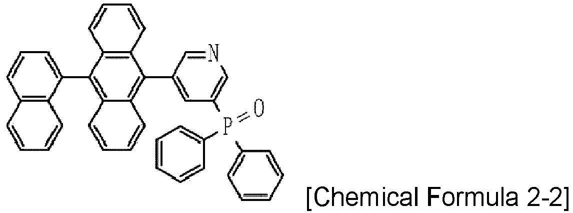

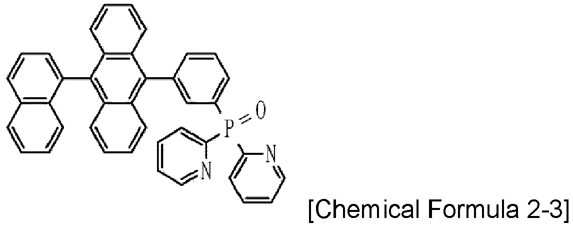

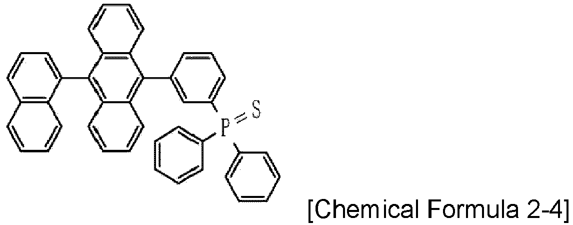

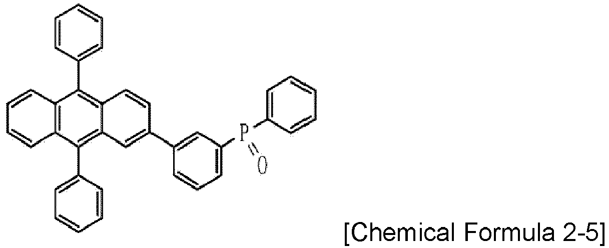

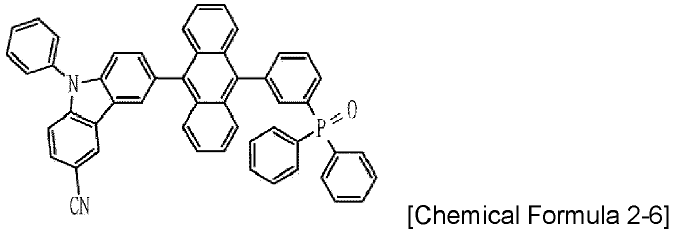

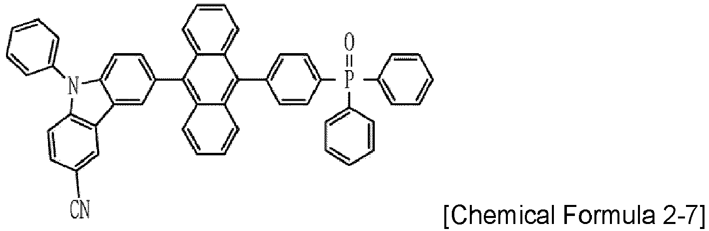

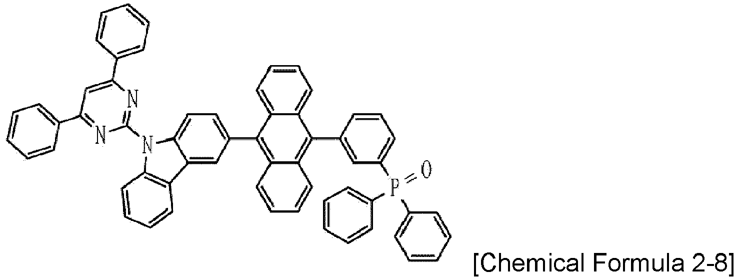

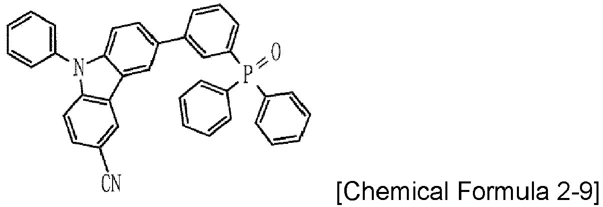

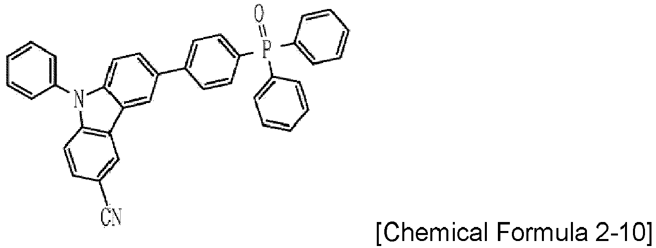

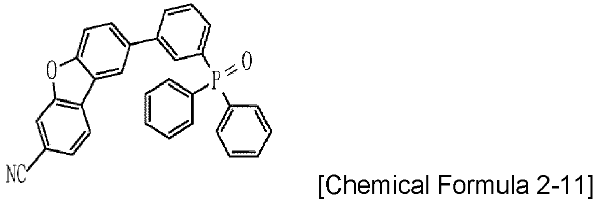

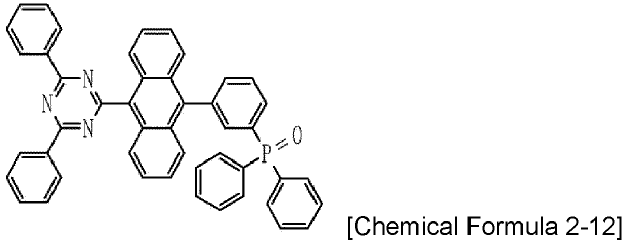

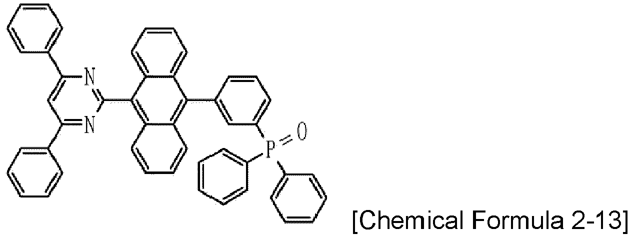

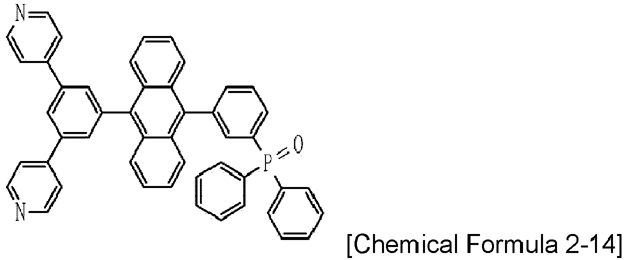

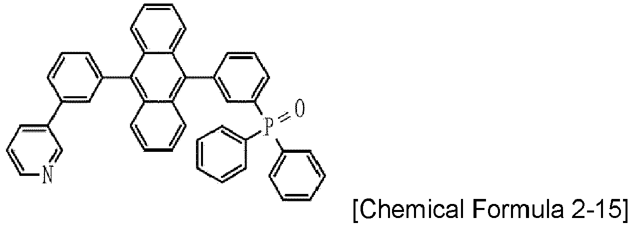

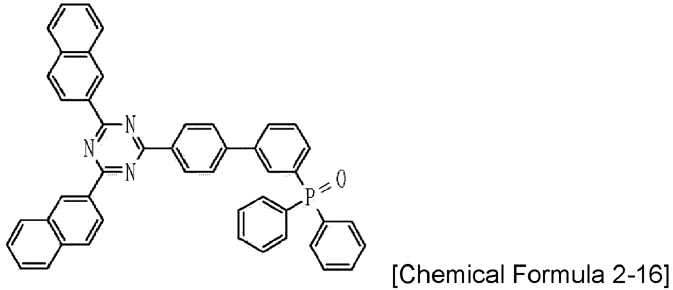

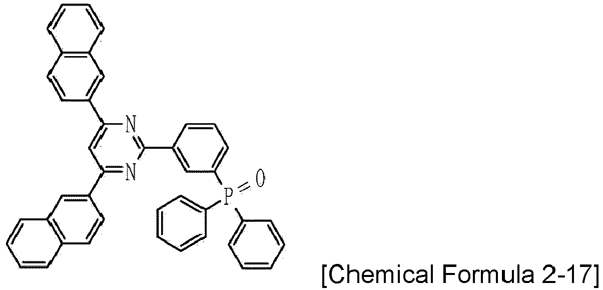

The dopant may include either an alkali metal or a lanthanum metal. The alkali metal may include lithium (Li), sodium (Na), potassium (K), rubidium (Rb), cesium (Cs), and francium (Fr). The lanthanum metal may include lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu).

The dopant may form a complex with the host.

For example, a host represented by Chemical Formula 1 may provide a compound represented by Chemical Formula 1-A below together with a dopant. In addition, a host represented by Chemical Formula 2 or Chemical Formula 2' may provide a compound represented by Chemical Formula 2-A below together with a dopant. In the following Chemical Formula 1-A and Chemical Formula 2-A, M is a dopant. 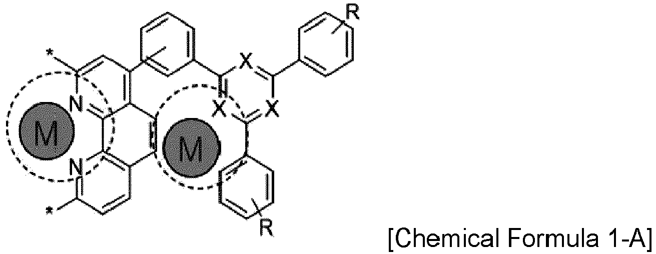 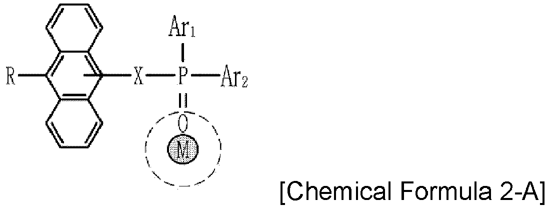 In Chemical Formula 1-A,
X is C or N,
R is one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-formed carbon atoms, a substituted or unsubstituted heteroaryl group having 2 to 30 ring-formed carbon atoms, containing a substituted or unsubstituted phenanthroline group, and
* means that any functional group can be linked,
in chemical Formula 2-A,
X, Ar₁ and Ar₂ are each one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-formed carbon atoms, and a substituted or unsubstituted heteroaryl group having 2 to 30 ring-formed carbon atoms.

When the metal is doped into the host as described above, as an effective LUMO level decreases, it is possible to reduce a driving voltage of the light emitting device and to improve luminous efficiency.

According to some embodiments, at least one of a plurality of n-type charge generating layers n-CGL1, n-CGL2, or n-CGL3 may include a dopant containing an alkali metal, and at least one of the remaining n-type charge generating layers n-CGL1, n-CGL2, or n-CGL3 may include a dopant containing a lanthanum metal.

For example, at least one of the (1-n)-th type of charge generating layer n-CGL1, the (2-n)-th type of charge generating layer n-CGL2, or the (3-n)-th type of charge generating layer n-CGL3 may include a dopant containing an alkali metal, and at least one of the (1-n)-th type of charge generating layer n-CGL1, the (2-n)-th type of charge generating layer n-CGL2, or the (3-n)-th type of charge generating layer n-CGL3 may include a dopant containing a lanthanum metal.

For example, one of the (1-n)-th type of charge generating layer n-CGL1, the (2-n)-th type of charge generating layer n-CGL2, and the (3-n)-th type of charge generating layer n-CGL3 may be doped with a dopant containing a lanthanum metal, and the other thereof may be doped with a dopant containing an alkali metal.

Alternatively, for example, two of the (1-n)-th type of charge generating layer n-CGL1, the (2-n)-th type of charge generating layer n-CGL2 and the (3-n)-th type of charge generating layer n-CGL3 may be doped with a dopant containing a lanthanum metal, and the other thereof may be doped with a dopant containing an alkali metal.

For example, the (1-n)-th type of charge generating layer n-CGL1 may includes a dopant containing a lanthanum metal, and the (2-n)-th type of charge generating layer n-CGL2 and the (3-n)-th type of charge generating layer n-CGL3 may include a dopant containing an alkali metal. Alternatively, for example, the (2-n)-th type of charge generating layer n-CGL2 may include a dopant containing a lanthanum metal, and the (1-n)-th type of charge generating layer n-CGL1 and the (3-n)-th type of charge generating layer n-CGL3 may include a dopant containing an alkali metal. Alternatively, for example, the (3-n)-th type of charge generating layer n-CGL3 may includes a dopant containing a lanthanum metal, and the (1-n)-th type of charge generating layer n-CGL1 and the (2-n)-th type of charge generating layer n-CGL2 may include a dopant containing an alkali metal.

In addition, the (1-n)-th type of charge generating layer n-CGL1 and the (2-n)-th type of charge generating layer n-CGL2 may include a dopant containing a lanthanum metal, and the (3-n)-th type of charge generating layer n-CGL3 may include a dopant containing an alkali metal. In addition, the (1-n)-th type of charge generating layer n-CGL1 and the (3-n)-th type of charge generating layer n-CGL3 may include a dopant containing a lanthanum metal, and the (2-n)-th type of charge generating layer n-CGL2 may include a dopant containing an alkali metal. Alternatively, the (2-n)-th type of charge generating layer n-CGL2 and the (3-n)-th type of charge generating layer n-CGL3 may include a dopant containing a lanthanum metal, and the (1-n)-th type of charge generating layer n-CGL1 may include a dopant containing an alkali metal.

For example, the lanthanum metal may be ytterbium (Yb), and the alkali metal may be lithium (Li).

Resistance of the n-type charge generating layers n-CGL1, n-CGL2, and n-CGL3 doped with the lanthanum metal according to some embodiments may be larger than that of the n-type charge generating layers n-CGL1, n-CGL2, and n-CGL3 doped with the alkali metal. By including the n-type charge generating layers n-CGL1, n-CGL2, and n-CGL3 doped with the lanthanum metal, a leakage current may be reduced.

The dopant may be doped with a content of 0.1 to 10 vol%. The alkali metal and the lanthanum metal doped in each of the n-type charge generating layers n-CGL1, n-CGL2, and n-CGL3 may be doped with different contents. The content of the alkali metal doped in the n-type charge generating layers n-CGL1, n-CGL2, and n-CGL3 may be smaller than that of the lanthanum metal. In some embodiments, when an alkali metal is doped into the n-type charge generating layers n-CGL1, n-CGL2, and n-CGL3, it may be included in an amount of about 0.1 to 3 vol%, and when a lanthanum metal is doped into the n-type charge generating layers n-CGL1, n-CGL2, and n-CGL3, it may be included in an amount of about 1 to 10 vol%.

A thickness of the n-type charge generating layers n-CGL1, n-CGL2, and n-CGL3 according to some embodiments may be about 20 to 200 angstroms.

The p-type charge generating layers p-CGL1, p-CGL2, and p-CGL3 may include a hole transporting organic compound, an inorganic insulator compound, or a combination thereof. The hole transporting organic compound will be described in detail later. In addition, the p-type charge generating layers p-CGL1, p-CGL2, and p-CGL3 may include one or more selected from inorganic semiconductor compounds.

A thickness of the p-type charge generating layers p-CGL1, p-CGL2, and p-CGL3 may be about 0.1 nm to about 20 nm.

The second electrode E2 is located on the m-th light emitting unit EL. The second electrode E2 may be a cathode that is an electron injection electrode, and in this case, as a material for the second electrode E2, a metal and an alloy having a low work function, an electrically conductive compound, and a combination thereof may be used.

The second electrode E2 may include one of lithium (Li), silver (Ag), magnesium (Mg), aluminum (Al), ytterbium (Yb), aluminum-lithium (Al-Li), calcium (Ca), magnesium-indium (Mg-In), silver-magnesium (Ag-Mg), silver-ytterbium (Ag-Yb), an ITO, and an IZO, but is not limited thereto. The second electrode E2 may be a transmissive electrode, a transflective electrode, or a reflective electrode.

The second electrode E2 may have a single-layered structure having a single layer, or a multi-layered structure having a plurality of layers.

A thickness of the second electrode E2 may be 5 nm to 20 nm. When the above-described range is satisfied, light absorption at the second electrode may be minimized, and a satisfactory electron injection characteristic may be obtained without a substantial increase in driving voltage.

In the light emitting device according to some embodiments, some of a plurality of n-type charge generating layers may be doped with an alkali metal, and some other thereof may be doped with a lanthanum metal. In this case, the n-type charge generating layer doped with the lanthanum metal may have higher resistance than the n-type charge generating layer doped with the alkali metal, and thus current leakage to a side surface of the light emitting device may be reduced. It may be possible to prevent or reduce instances of unintentional pixels from lighting up due to the leakage current to the side surface, and thus to provide relatively improved display quality.

Hereinafter referring to FIG. 2, a detailed stacked structure of each light emitting unit according to some embodiments will be described. An example that includes four light emitting units according to some embodiments will be described. A description of the constituent elements described above may be omitted.

Each light emitting unit EL may include a light emitting layer EML. In addition, each light emitting unit EL may include at least one of a hole transport region HTR or an electron transport region ETR. The hole transport region HTR may include a hole injection layer, a hole transport layer, an electron blocking layer, or a combination thereof. The electron transport region ETR may include a hole blocking layer, an electron transport layer, an electron injection layer, or a combination thereof. Each light emitting unit EL may include a light emitting layer EML, a hole transport region HTR, of an electron transport region ETR containing different materials, or may include a light emitting layer EML, a hole transport region HTR, or an electron transport region ETR containing the same material.

The first light emitting unit EL1 may include a first light emitting layer EML1 that emits light, a first hole transport region HTR1 that transports holes provided from the first electrode E1 to the first light emitting layer EML1, and a first electron transport region ETR1 that transports electrons generated from the first charge generating layer CGL1 to the first light emitting layer EML1.

The second light emitting unit EL2 may include a second light emitting layer EML2 that emits light, a second hole transport region HTR2 that transports holes provided from the first charge generating layer CGL1 to the second light emitting layer EML1, and a second electron transport region ETR2 that transports electrons generated from the second charge generating layer CGL2 to the second light emitting layer EML2.

The third light emitting unit EL3 may include a third light emitting layer EML3 that emits light, a third hole transport region HTR3 that transports holes provided from the second charge generating layer CGL2 to the third light emitting layer EML3, and a third electron transport region ETR3 that transports electrons generated from the third charge generating layer CGL3 to the third light emitting layer EML3.

The fourth light emitting unit EL4 may include a fourth light emitting layer EML4 that emits light, a fourth hole transport region HTR4 that transports holes provided from the third charge generating layer CGL3 to the fourth light emitting layer EML4, and a fourth electron transport region ETR4 that transports electrons generated from the second electrode E2 to the fourth light emitting layer EML4.

The hole transport region HTR may be formed by using a general method known in the art. For example, the hole transport region HTR may be formed by using various methods such as a vacuum deposition method, a spin coating method, a casting method, a Langmuir-Blodgett (LB) method, an inkjet printing method, a laser printing method, a laser induced thermal imaging (LITI) method, and the like.

The hole injection layer included in the hole transport region HTR may include a hole injection material. The hole injection material may include a phthalocyanine compound such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-[tris(3-methylphenyl)phenylamino] triphenylamine), TDATA (4,4'4"-tris(N,N-diphenylamino)triphenylamine), 2-TNATA (4,4',4"-tris{N,-(2-naphthyl)-N-phenylamino}-triphenylamine), PEDOT/PSS (Poly(3,4-ethylenedioxythiophene)/Poly(4-styrenesulfonate)), PANI/DBSA (polyaniline/dodecylbenzenesulfonic acid), PANI/CSA (polyaniline/camphor sulfonic acid), PANI/PSS (polyaniline/poly(4-styrenesulfonate)), NPB (N,N'-di(naphthalene-l-yl)-N,N'-diphenyl-benzidine), NPD(N,N'-Di (1-naphthyl)-N,N'-diphenyl- (1,1'-biphenyl)-4,4'-diamine), polyether ketone containing triphenylamine (TPAPEK), 4-isopropyl-4'-methyldiphenyliodonium [tetrakis(pentafluorophenyl)borate], HAT-CN (dipyrazino[2,3-f: 2',3'-h] quinoxaline-2,3,6,7,10,11-hexacarbonitrile), and the like.

The hole transport layer included in the hole transport region may include a hole transport material. The hole transport material may include carbazole derivatives such as N-phenylcarbazole and polyvinylcarbazole, fluorene-based derivatives, TPD (N,N'-bis(3-methylphenyl)-N,N'-diphenyl-[1,1-biphenyl]-4,4'-diamine), TCTA (4,4',4"-tris(N-carbazolyl) triphenylamine), such as triphenylamine derivatives, NPB (N,N'-di(naphthalene-l-yl)-N,N'-diphenyl-benzidine), TAPC (4,4'-cyclohexylidene bis[N,N-bis(4-methylphenyl)benzenamine]), HMTPD(4,4'-bis[N,N'-(3-tolyl)amino]-3,3'-dimethylbiphenyl), mCP (1,3-bis(N-carbazolyl)benzene), CzSi (9-(4-tert-butylphenyl)-3,6-bis(triphenylsilyl)-9H-carbazole), m-MTDATA (4,4',4"-[tris(3-methylphenyl)phenylamino] triphenylamine), and the like.

A thickness of the hole transport region HTR may be about 100 Å to about 10,000 Å, for example, about 100 Å to about 5000 Å. A thickness of the hole injection layer may be, for example, about 30 Å to about 1000 Å, and a thickness of the hole transport layer may be about 30 Å to about 1000 Å. When the thicknesses of the hole transport region HTR, the hole injection layer, and the hole transport layer satisfy the above-mentioned ranges, a satisfactory hole transport characteristic may be obtained without a substantial increase in driving voltage.

The electron blocking layer is a layer that prevents or reduces instances of electrons leaking from the electron transport region ETR to the hole transport region HTR. A thickness of the electron blocking layer may be about 10 Å to about 1000 Å. The electron blocking layer may include, for example, carbazole derivatives such as N-phenylcarbazole and polyvinylcarbazole, fluorene derivatives, triphenylamine derivatives such as TPD (N,N'-bis(3-methylphenyl)-N,N'-diphenyl-[1,1-biphenyl]-4,4'-diamine) and TCTA (4,4',4"-tris(N -carbazolyl) triphenylamine), NPD (N,N'-di(naphthalene-l-yl)-N,N'-diphenyl-benzidine), TAPC (4,4'-cyclohexylidene bis[N,N-bis(4-methylphenyl)benzenamine]), HMTPD (4,4'-bis[N,N'-(3-tolyl)amino]-3,3'-dimethylbiphenyl), or mCP.

The hole transport region HTR may further include a charge generating material for conductive improvement in addition to the above-mentioned materials. The charge generating material may be uniformly or non-uniformly dispersed in the hole transport region HTR. The charge generating material may be, for example, a p-dopant. The p-dopant may be one of a quinone derivative, a metal oxide, and a cyano group-containing compound, but is not limited thereto. For example, non-limiting examples of p-dopants include quinone derivatives such as TCNQ (tetracyanoquinodimethane) and F4-TCNQ (2,3,5,6-tetrafluoro-7,7',8,8'-tetracyanoquinodimethane), and metal oxides such as tungsten oxide and molybdenum oxide, but are not limited thereto.

Each layer of the electron transport region ETR may be formed by using general methods known in the art. For example, the electron transport region ETR may be formed by using various methods such as a vacuum deposition method, a spin coating method, a casting method, a Langmuir-Blodgett (LB) method, an inkjet printing method, a laser printing method, a laser induced thermal imaging (LITI) method, and the like.

The electron injection layer included in the electron transport region ETR may include an electron injection material. As the electron injection material, a metal halide such as LiF, NaCl, CsF, RbCI, and RbI, a lanthanide metal such as Yb, a metal oxide such as Li₂O and BaO, or a lithium quinolate (LiQ) may be used, but embodiments according to the present invention are not limited thereto.

The electron injection layer may also be made of a material in which an electron transport material and an insulating organometal salt are mixed. The organometal salt may be a material having an energy band gap of about 4 eV or more. For example, the organometal salt may include a metal acetate, a metal benzoate, a metal acetoacetate, a metal acetylacetonate, or a metal stearate.

The electron transport layer included in the electron transport region ETR may include an electron transport material. The electron transport material may include an anthracene-based compound. However, embodiments according to the present invention are not limited thereto, and the electron transport material may include, for example, Alq₃ (tris(8-hydroxyquinolinato)aluminum), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, TPBi (1,3,5-tris(1-phenyl-1H-benzo[d]imidazol-2-yl)benzene), BCP (2,9-dimethyl-4,7-diphenyl-1,10-phenanthroline), BPhen (4,7-diphenyl-1,10-phenanthroline), TAZ (3-(4-biphenylyl)-4-phenyl-5-tert-butylphenyl-1,2,4-triazole), NTAZ (4-(naphthalen-1-yl)-3,5-diphenyl-4H-1,2,4-triazole), tBu-PBD (2-(4-biphenylyl)-5-(4-tert-butylphenyl)-1,3,4-oxadiazole), BAlq (bis(2-methyl-8-quinolinolato-N1,O8)-(1,1'-biphenyl-4-olato)aluminum), Bebq₂ (beryllium bis(benzoquinolin-10-olate), ADN (9,10-di(naphthalene-2-yl)anthracene), TSPO1 (diphenyl(4-(triphenylsilyl)phenyl)phosphine oxide), TPM-TAZ (2,4,6-tris(3-(pyrimidin-5-yl)phenyl)-1,3,5-triazine), and a mixture thereof.

Each of the electron injection layers may have a thickness of about 1 Å to about 500 Å, or about 3 Å to about 300 Å. When the thickness of the electron injection layer satisfies the range as described above, a satisfactory electron injection characteristic may be obtained without a substantial increase in driving voltage.

Each of the electron transport layers may have a thickness of about 100 Å to about 1000 Å, for example, about 150 Å to about 500 Å. When the thickness of the electron transport layer satisfies the range as described above, a satisfactory electron transport characteristic may be obtained without a substantial increase in driving voltage.

The hole blocking layer is a layer that prevents or reduces instances of holes leaking from the hole transport region HTR to the electron transport region ETR. A thickness of the hole blocking layer may be about 10 Å to about 1000 Å.

The hole blocking layer may include, for example, at least one of BCP (2,9-dimethyl-4,7-diphenyl-1,10-phenanthroline), BPhen (4,7-diphenyl-1,10-phenanthroline), or T2T (2,4,6-tri([1,1'-biphenyl]-3-yl)-1,3,5-triazine), but embodiments according to the present disclosure are not limited thereto.

Meanwhile, each of the light emitting units EL includes a light emitting layer EML. For example, one light emitting layer EML may be included per one light emitting unit EL. A plurality of light emitting layers EML may each emit light of different colors or may emit light of the same color. According to some embodiments, the first to third light emitting layers EML1, EML2, and EML3 included in the first to third light emitting units EL1, EL2, and EL3 may emit blue light, and the fourth light emitting layer EML4 may emit green light, but embodiments according to the present invention are not limited thereto.

The light emitting layer EML may include at least one of an organic compound or a semiconductor compound, but embodiments according to the present disclosure are not limited thereto. When the light emitting layer EML contains an organic compound, the light emitting device may be referred to as an organic light emitting device.

The organic compound may include a host and a dopant. The semiconductor compound may be a quantum dot, that is, the light emitting device may be a quantum dot light emitting device. Alternatively, the semiconductor compound may be an organic and/or inorganic perovskite.

A thickness of the light emitting layer EML may be about 0.1 nm to about 100 nm. For example, the thickness of the light emitting layer EML may be 15 nm to 50 nm. For example, when the light emitting layer EML emits blue light, a thickness of the blue light emitting layer may be 15 nm to 20 nm, and when the light emitting layer emits green light, a thickness of the green light emitting layer may be 20 nm to 40 nm, while when the light emitting layer emits red light, a thickness of the red light emitting layer may be 40 nm to 50 nm. When the above-mentioned range is satisfied, the light emitting device may provide an excellent light emitting characteristic without a substantial increase in driving voltage.

The light emitting layer EML may include a host material and a dopant material. The light emitting layer EML may be formed by using a phosphorescent or fluorescent light emitting material as a dopant in a host material. The light emitting layer EML may be formed by including a thermally activated delayed fluorescence (TADF) dopant in a host material. Alternatively, the light emitting layer EML may include a quantum dot material as a light emitting material. A core of the quantum dot may be selected from a group II-VI compound, a group III-V compound, a group IV-VI compound, a group IV element, a group IV compound, and a combination thereof.

A color of light emitted from the light emitting layer EML may be determined by a combination of a host material and a dopant material, or a type of quantum dot material and a size of a core.

As the host material of the light emitting layer EML, a known material may be used, and although not particularly limited, it is selected from a fluoranthene derivative, a pyrene derivative, an arylacetylene derivative, an anthracene derivative, a fluorene derivative, a perylene derivative, a chrysene derivative, and the like. According to some embodiments, the pyrene derivative, the perylene derivative, and the anthracene derivative may be selected.

As the dopant material of the light emitting layer EML, a known material may be used, and although not particularly limited, it may include styryl derivatives (for example, 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), perylene and its derivatives (for example, 2,5,8,11-tetra-t-butylperylene (TBP)), and pyrene and its derivatives (for example, 1,1-dipyrene, 1,4-dipyrenylbenzene, 1,4-bis(N, N-diphenylamino)pyrene), and N1,N6-di(naphthalen-2-yl)-N1,N6-diphenylpyrene-1,6-diamine).

The light emitting device may further include a capping layer CPL located on the second electrode E2. The capping layer CPL may include, for example, α-NPD, NPB, TPD, m-MTDATA, Alq3, CuPc, TPD15 (N4,N4,N4',N4'-tetra(biphenyl-4-yl)biphenyl-4,4'-diamine), TCTA (4,4',4"-tris(N-carbazolyl)triphenylamine), and N,N'-bis(naphthalen-1-yl). The capping layer CPL serves to efficiently emit light emitted from the light emitting layer EML of the light emitting device to the outside of the light emitting device. When the light emitting device of the embodiments further includes a thin film encapsulation layer, the capping layer CPL may be located between the second electrode E2 and the thin film encapsulation layer.

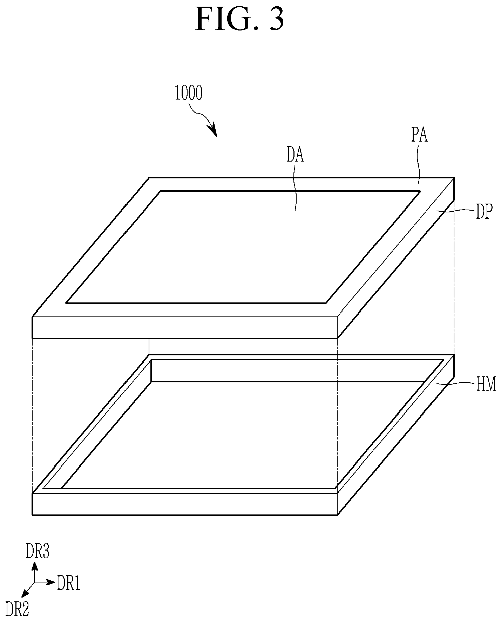

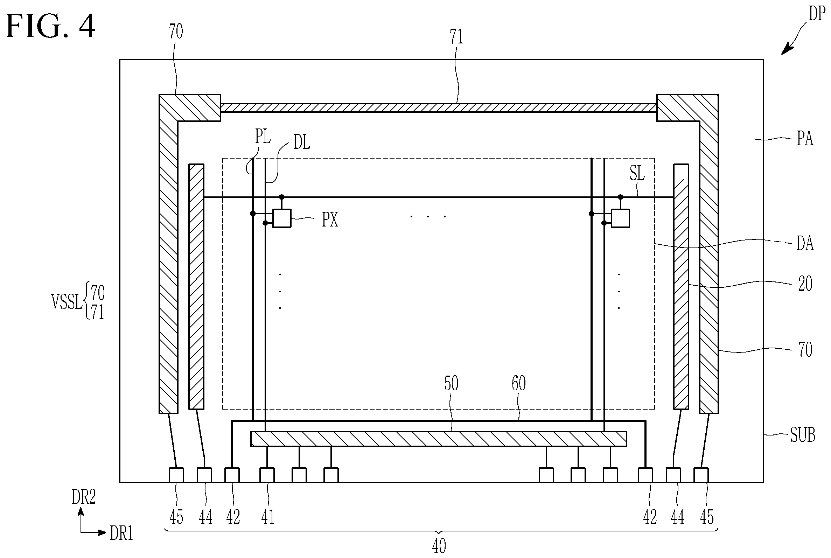

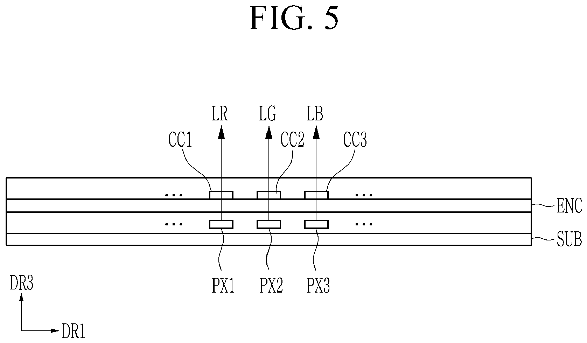

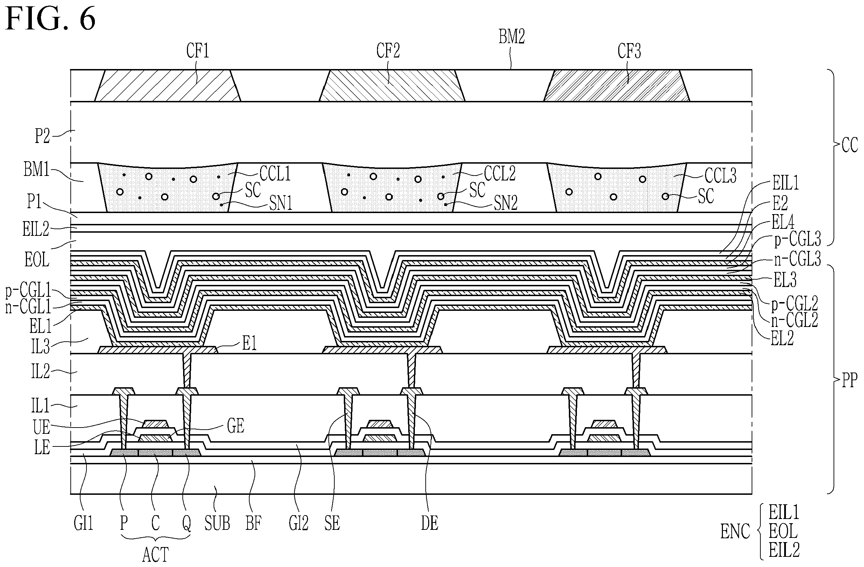

Hereinafter, a display device according to some embodiments will be described in more detail with reference to FIG. 3 to FIG. 6. FIG. 3 illustrates a schematic exploded perspective view of a display device according to some embodiments, FIG. 4 illustrates a top plan view of a display panel according to some embodiments, FIG. 5 illustrates a schematic cross-sectional view of a display panel according to some embodiments, and FIG. 6 illustrates a cross-sectional view of a display panel according to some embodiments .

First, referring to FIG. 3, a display device 1000 according to some embodiments may include a display panel DP and a housing HM.

One surface of the display panel DP on which an image is displayed is parallel to a surface defined by a first direction DR1 and a second direction DR2. A third direction DR3 indicates a normal direction of the surface on which the image is displayed, that is, a thickness direction of the display panel DP. A front surface (or upper surface) and a back surface (or lower surface) of each member are divided by the third direction DR3. However, directions indicated by the first to third directions DR1, DR2, and DR3 are relative concepts, and thus they may be changed into other directions.

The display panel DP may be a flat rigid display panel, but is not limited thereto, and may be a flexible display panel. Meanwhile, the display panel DP may be formed of a light emitting display panel.

The display panel DP includes a display area DA in which an image is displayed, and a non-display area PA adjacent to the display area DA. The non-display area PA is an area in which no image is displayed. The display area DA may have, for example, a quadrangular shape, and the non-display area PA may have a shape surrounding the display area DA. However, embodiments according to the present invention are not limited thereto, and the shapes of the display area DA and the non-display area PA may be relatively designed.

The housing HM provides an inner space (e.g., a set or predetermined inner space). The display panel DP is mounted inside the housing HM. In addition to the display panel DP, various electronic components, for example, a power supply part, a storage device, and an audio input/output module, may be mounted inside the housing HM.

Referring to FIG. 4, the display panel DP includes the display area DA and the non-display area PA. The non-display area PA may be defined along an edge of the display area DA.

The display panel DP includes a plurality of pixels PX. The plurality of pixels PX may be located in the display area DA on a substrate SUB. Each of the pixels PX includes an organic light emitting diode and a pixel driving circuit connected to the organic light emitting diode.

Each pixel PX emits, for example, red, green, blue, or white light, and may include a light emitting diode as an example. The display panel DP displays an image (e.g., a set or predetermined image) through the light emitted from the pixels PX, and the display area DA is defined by the pixels PX. In the present specification, the non-display area PA is an area in which the pixels PX are not arranged, and indicates an area that does not display images.

The display panel DP may include a plurality of signal lines and a pad part. The plurality of signal lines may include a scan line SL extending in the first direction DR1, and a data line DL and a driving voltage line PL extending in the second direction DR2.

A scan driver 20 is located in the non-display area PA on the substrate SUB. The scan driver 20 generates a scan signal to transmit it to each pixel PX through the scan line SL. According to some embodiments, the scan driver 20 may be located at left or right sides of the display area DA. In the present specification, a structure in which the scan driver 20 is located at both sides of the display area DA is shown, but according to some embodiments, the scan driver may be located only at one side of the display area DA.

A pad part 40 is located at one end portion of the display panel DP, and includes a plurality of terminals 41, 42, 44, and 45. The pad part 40 may be exposed without being covered by the insulating layer, and may be electrically connected to a controller such as a flexible printed circuit board or an IC chip.

The controller converts a plurality of image signals transmitted from the outside into a plurality of image data signals, and transmits the converted signals to a data driver 50 through a terminal 41. In addition, the controller may receive a vertical synchronization signal, a horizontal synchronization signal, and a clock signal, and may generate a control signal for controlling operations of the scan driver 20 and the data driver 50 to transmit it to each of the scan driver 20 and the data driver 50 through terminals 44 and 41. The controller transmits a driving voltage ELVDD to a driving voltage supply line 60 through a terminal 42. In addition, the controller transmits a common voltage to each of common voltage supply lines VSSL through a terminal 45.

The data driver 50 is arranged at the non-display area PA, and generates a data signal to transmit it to each pixel PX through the data line DL. The data driver 50 may be located at one side of the display panel DP, and for example, may be located between the pad part 40 and the display part 10.

The driving voltage supply line 60 is located on the non-display area PA. For example, the driving voltage supply line 60 may be located between the data driver 50 and the display area DA. The driving voltage supply line 60 provides a driving voltage to the pixels PX. The driving voltage supply line 60 may be arranged in the first direction DR1, and may be connected to a plurality of driving voltage lines PL arranged in the second direction DR2.

The common voltage supply line VSSL is arranged at the non-display area PA, and provides a common voltage ELVSS to a common electrode of an organic light emitting device of the pixel PX. The common voltage supply line VSSL may extend from one side surface of the substrate SUB to form a closed loop surrounding three surfaces along an edge of the substrate SUB.

The common voltage supply line VSSL may include a main supply line 70, a sub-supply line 71, and the like.

Referring to FIG. 5, a plurality of pixels PX1, PX2, and PX3 may be formed on the substrate SUB corresponding to the display area DA. Each of the pixels PX1, PX2, and PX3 may include a plurality of transistors and a light emitting device connected thereto. A specific stacked structure will be described with reference to FIG. 6. The plurality of pixels PX1, PX2, and PX3 may emit light of the same color or light of different colors.

An encapsulation layer ENC may be formed on the plurality of pixels PX1, PX2, and PX3. The display area DA may be protected from external air or moisture through the encapsulation layer ENC. The encapsulation layer ENC may be integrally provided to overlap the entire display area DA, and may be partially arranged at the non-display area PA.

A first color conversion part CC1, a second color conversion part CC2, and a third color conversion part CC3 may be formed on the encapsulation layer ENC. The light emitted from the first to third pixels PX1, PX2, and PX3 may pass through the first to third color conversion parts CC1, CC2, and CC3 to emit red light LR, green light LG, and blue light LB, respectively.

Referring to FIG. 6, the display panel according to some embodiments may include a pixel part PP and a color conversion part CC located on the pixel part PP.

The pixel portion PP including the plurality of pixels PX1, PX2, and PX3 located on the substrate SUB described in FIG. 5 will be first described.

The substrate SUB may include an inorganic insulating material such as glass or an organic insulating material such as plastic such as polyimide (PI). The substrate SUB may be single-layered or multi-layered. The substrate SUB may have a structure in which at least one base layer and at least one inorganic layer, which include polymer resins sequentially stacked, are alternately stacked.

The substrate SUB may have various degrees of flexibility. The substrate SUB may be a rigid substrate, or a flexible substrate that is bendable, foldable, or rollable.

A buffer layer BF may be formed on the substrate SUB. The buffer layer BF blocks impurities from being transmitted from the substrate SUB to an upper layer of the buffer layer BF, particularly a semiconductor layer ACT, thereby preventing or reducing characteristic degradation of the semiconductor layer ACT and reducing stress. The buffer layer BF may include an inorganic insulating material such as a silicon nitride or silicon oxide, or an organic insulating material. A portion or all of the buffer layer BF may be omitted.

The semiconductor layer ACT is formed on the buffer layer BF. The semiconductor layer ACT may include at least one of polycrystalline silicon or an oxide semiconductor. The semiconductor layer ACT includes a channel area (C), a first area (P), and a second area (Q). The first area (P) and the second area (Q) are arranged at both sides of the channel area (C), respectively. The channel area (C) may include a semiconductor with a small amount of impurity doped or a semiconductor with no impurity doped, and the first area (P) and the second area (Q) may include semiconductors with a large amount of impurity doped compared to the channel area (C). The semiconductor layer ACT may be formed of an oxide semiconductor, and in this case, a separate passivation layer may be added to protect an oxide semiconductor material that is vulnerable to external environments such as high temperature.

The first gate insulating layer GI1 is located on the semiconductor layer ACT.

A gate electrode GE and a lower electrode LE are located on the first gate insulating layer GI1. In some embodiments, the gate electrode GE and the lower electrode LE may be integrally formed. The gate electrode GE and the lower electrode LE may be a single layer or multilayer in which metal films containing one of copper (Cu), a copper alloy, aluminum (Al), an aluminum alloy, molybdenum (Mo), a molybdenum alloy, titanium (Ti), and a titanium alloy are stacked. The gate electrode GE may overlap the channel area (C) of the semiconductor layer ACT.

A second gate insulating layer GI2 may be located on the gate electrode GE and the first gate insulating layer GI1. The first gate insulating layer GI1 and the second gate insulating layer GI2 may be a single layer or multilayer including at least one of a silicon oxide (SiOₓ), a silicon nitride (SiNₓ), or a silicon oxynitride (SiOₓN_{y}).

An upper electrode UE may be located on the second gate insulating layer GI2. The upper electrode UE may form a storage capacitor while overlapping the lower electrode LE.

A first interlayer insulating layer IL1 is located on the upper electrode UE. The first interlayer insulating layer IL1 may be a single layer or multilayer including at least one of a silicon oxide (SiOₓ), a silicon nitride (SiNₓ), or a silicon oxynitride (SiOₓN_{y}).

A source electrode SE and a drain electrode DE are located on the first interlayer insulating layer IL1. The source electrode SE and the drain electrode DE are connected to the first area (P) and the second area (Q) of the semiconductor layer ACT through a contact hole formed in the insulating layers, respectively.

The source electrode CE and the drain electrode DE may include aluminum (Al), silver (Ag), magnesium (Mg), gold (Au), nickel (Ni), chromium (Cr), calcium (Ca), molybdenum (Mo), titanium (Ti), tungsten (W), and/or copper (Cu), and may have a single-layered or multi-layered structure including them.

A second interlayer insulating layer IL2 is located on the first interlayer insulating layer IL1, the source electrode SE, and the drain electrode DE. The second interlayer insulating layer IL2 may include an organic insulating material such as a general purpose polymer such as polymethylmethacrylate (PMMA) or polystyrene (PS), a polymer derivative having a phenolic group, a acryl-based polymer, an imide-based polymer, a polyimide, an acryl-based polymer, and a siloxane-based polymer.

The first electrode E1 may be located on the second interlayer insulating layer IL2. The first electrode E1 may be connected to the drain electrode DE through a contact hole of the second interlayer insulating layer IL2.

The first electrode E1 may contain a metal such as silver (Ag), lithium (Li), calcium (Ca), aluminum (Al), magnesium (Mg), or gold (Au), and may also contain a transparent conductive oxide (TCO) such as an indium tin oxide (ITO) or an indium zinc oxide (IZO). The first electrode E1 may be formed of a single layer including a metal material or a transparent conductive oxide, or a multilayer including them. For example, the first electrode E1 may have a triple-layered structure of indium tin oxide (ITO)/silver (Ag)/indium tin oxide (ITO).

A transistor configured of the gate electrode GE, the semiconductor layer ACT, the source electrode SE, and the drain electrode DE is connected to the first electrode E 1 to supply a current to a light emitting device.

A partition wall IL3 is located on the second interlayer insulating layer IL2 and the first electrode E1. According to some embodiments, a space r may be located on the partition wall IL3. The partition wall IL3 overlaps at least a portion of the first electrode E1, and has a partition wall opening defining a light emitting region.

The partition wall IL3 may include an organic insulating material such as a general purpose polymer such as polymethylmethacrylate (PMMA) or polystyrene (PS), a polymer derivative having a phenolic group, an acryl-based polymer, an imide-based polymer, a polyimide, an acryl-based polymer, and a siloxane-based polymer.

The first light emitting unit EL1, the (1-n)-th type of charge generating layer n-CGL1, the (1-p)-th type of charge generating layer p-CGL1, the second light emitting unit EL2, the (2-n)-th type of charge generating layer n-CGL2, the (2-p)-th type of charge generating layer p-CGL2, the third light emitting unit EL3, the (3-n)-th type of charge generating layer n-CGL3, the (3-p)-th type of charge generating layer p-CGL3, and the fourth light emitting unit EL4 may be sequentially arranged on the partition wall IL3. The first light emitting unit EL1, the (1-n)-th type of charge generating layer n-CGL1, the (1-p)-th type of charge generating layer p-CGL1, the second light emitting unit EL2, the (2-n)-th type of charge generating layer n-CGL2, the (2-p)-th type of charge generating layer p-CGL2, the third light emitting unit EL3, the (3-n)-th type of charge generating layer n-CGL3, the (3-p)-th type of charge generating layer p-CGL3, and the fourth light emitting unit EL4 may be entirely commonly arranged on a plurality of pixel areas. However, embodiments according to the present invention are not limited thereto, and at least some of the first light emitting unit EL1, the (1-n)-th type of charge generating layer n-CGL1, the (1-p)-th type of charge generating layer p-CGL1, the second light emitting unit EL2, the (2-n)-th type of charge generating layer n-CGL2, the (2-p)-th type of charge generating layer p-CGL2, the third light emitting unit EL3, the (3-n)-th type of charge generating layer n-CGL3, the (3-p)-th type of charge generating layer p-CGL3, and the fourth light emitting unit EL4 may be patterned and located only in the opening of the partition wall IL3. For the detailed description of the first light emitting unit EL1, the (1-n)-th type of charge generating layer n-CGL1, the (1-p)-th type of charge generating layer p-CGL1, the second light emitting unit EL2, the (2-n)-th type of charge generating layer n-CGL2, the (2-p)-th type of charge generating layer p-CGL2, the third light emitting unit EL3, the (3-n)-th type of charge generating layer n-CGL3, the (3-p)-th type of charge generating layer p-CGL3, and the fourth light emitting unit EL4, the description of the light emitting device according to some embodiments described above with reference to FIG. 1 and FIG. 2 may be applied.

The second electrode E2 is located on the fourth light emitting unit EL4. The second electrode E2 may include a reflective metal including calcium (Ca), barium (Ba), magnesium (Mg), aluminum (Al), silver (Ag), gold (Au), nickel (Ni), chromium (Cr), lithium (Li), or calcium (Ca), or a transparent conductive oxide (TCO) such as an indium tin oxide (ITO) or an indium zinc oxide (IZO).

The first light emitting unit EL1, the (1-n)-th type of charge generating layer n-CGL1, the (1-p)-th type of charge generating layer p-CGL1, the second light emitting unit EL2, the (2-n)-th type of charge generating layer n-CGL2, the (2-p)-th type of charge generating layer p-CGL2, the third light emitting unit EL3, the (3-n)-th type of charge generating layer n-CGL3, the (3-p)-th type of charge generating layer p-CGL3, the fourth light emitting unit EL4, and the second electrode E2 may form a light emitting device. Here, the first electrode E1 may be an anode, which is a hole injection electrode, and the second electrode E2 may be a cathode, which is an electron injection electrode. However, the embodiments are not necessarily limited thereto, and the first electrode E1 may be a cathode and the second electrode E2 may be an anode, according to a driving method of the light emitting display device.

The encapsulation layer ENC is located on the second electrode E2. The encapsulation layer ENC may cover and seal not only an upper surface but also a side surface of the light emitting device. Since the light emitting device is very vulnerable to moisture and oxygen, the encapsulation layer ENC seals the light emitting device to block inflow of moisture and oxygen from the outside.

The encapsulation layer ENC may include a plurality of layers, and in this case, it may be formed as a composite film including both an inorganic layer and an organic layer, and for example, it may be formed as a triple layer in which a first encapsulation inorganic layer EIL1, an encapsulation organic layer EOL, and a second encapsulation inorganic layer EIL2 are sequentially formed.

The first encapsulation inorganic layer EIL1 may cover the second electrode E2. The first encapsulation inorganic layer EIL1 may prevent or reduce external moisture or oxygen from penetrating into the light emitting device. For example, the first encapsulation inorganic layer EIL1 may include a silicon nitride, a silicon oxide, a silicon oxynitride, or a combination thereof. The first encapsulation inorganic layer EIL1 may be formed through a deposition process.

The encapsulation organic layer EOL may be located on the first encapsulation inorganic layer EIL1 to contact the first encapsulation inorganic layer EIL1. Curved portions formed on an upper surface of the first encapsulation inorganic layer EIL1 or particles being present on the first encapsulation inorganic layer EIL1 are covered by the encapsulation organic layer EOL, so that influence on constituent elements formed on the encapsulation organic layer EOL by the surface state of the upper surface of the first encapsulation inorganic layer EIL1 may be blocked. In addition, the encapsulation organic layer EOL may reduce stress between layers in contact with each other. The encapsulation organic layer EOL may include an organic material, and may be formed through a solution process such as spin coating, slit coating, or an inkjet process.

The second encapsulation inorganic layer EIL2 is located on the encapsulation organic layer EOL to cover the encapsulation organic layer EOL. The second encapsulation inorganic layer EIL2 may be stably formed on a relatively flat surface compared to the first encapsulation inorganic layer EIL1. The second encapsulation inorganic layer EIL2 encapsulates moisture discharged from the encapsulation organic layer EOL to prevent or reduce outflow to the outside. The second encapsulation inorganic layer EIL2 may include a silicon nitride, a silicon oxide, a silicon oxynitride, or a combination thereof. The second encapsulation inorganic layer EIL2 may be formed through a deposition process.

According to some embodiments, a capping layer located between the second electrode E2 and the encapsulation layer ENC may be further included. The capping layer may include an organic material. The capping layer protects the second electrode E2 from a subsequent process, for example, a sputtering process, and improves light emitting efficiency of the light emitting device. The capping layer may have a larger refractive index than that of the first encapsulation inorganic layer EIL1.

The color conversion part CC is located on the encapsulation layer ENC.

The color conversion part CC includes a first insulating layer P1 located on the encapsulation layer ENC. The first insulating layer P1 may be integrally formed to overlap the entire display area. The first insulating layer P1 may be a single layer or multilayer including at least one of a silicon oxide (SiOₓ), a silicon nitride (SiNₓ), or a silicon oxynitride (SiOₓN_{y}).

A first light blocking layer BM1 may be located on the first insulating layer P1. The first light blocking layer BM1 may define an area in which a first color conversion layer CCL1, a second color conversion layer CCL2, and a transmission layer CCL3 are located.

The first color conversion layer CCL1, the second color conversion layer CCL2, and the transmission layer CCL3 are located in the area defined by the first light blocking layer BM1. The first color conversion layer CCL1, the second color conversion layer CCL2, and the transmission layer CCL3 may be formed by an inkjet process, but embodiments according to the present disclosure are not limited thereto, and may be formed by using any manufacturing method.

The transmission layer CCL3 transmits light of a first wavelength incident from the light emitting device, and may include a plurality of scatterers SC. In this case, the light of the first wavelength may be blue light having a maximum light emitting peak wavelength of about 380 nm to about 480 nm, for example, about 420 nm or more, about 430 nm or more, about 440 nm or more, or about 445 nm or more, and about 470 nm or less, about 460 nm or less, or about 455 nm or less.

The first color conversion layer CCL1 may color-convert light of the first wavelength incident from the light emitting device into red light, and may include a plurality of scatterers SC and a plurality of first quantum dots SN1. In this case, the red light may have a maximum light emitting peak wavelength of about 600 nm to about 650 nm, for example, about 620 nm to about 650 nm.

The second color conversion layer CCL2 may color-convert light of the first wavelength incident from the light emitting device into green light, and may include a plurality of scatterers SC and a plurality of second quantum dots SN2. The green light may have a maximum light emitting peak wavelength of about 500 nm to about 550 nm, for example, about 510 nm to about 550 nm.

The plurality of scatterers SC may scatter light incident on the first color conversion layer CCL1, the second color conversion layer CCL2, and the transmission layer CCL3 to increase light efficiency.

Each of the first quantum dot SN1 and the second quantum dot SN2 (hereinafter, also referred to as a semiconductor nanocrystal) may independently include a group II-VI compound, a group III-V compound, a group IV-VI compound, a group IV element or compound, a group I-III-VI compound, a group II-III-VI compound, a group I-II-IV-VI compound, or a combination thereof. The quantum dot may not include cadmium.

The group II-VI compound may be selected from a two-element compound selected from CdSe, CdTe, ZnS, ZnSe, ZnTe, ZnO, HgS, HgSe, HgTe, MgSe, MgS, and a mixture thereof; a three-element compound selected from AglnS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a four-element compound selected from HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof. The group II-VI compound may further include a group III metal.

The group III-V compound may be selected from a two-element compound selected from GaN, GaP, GaAs, GaSb, AIN, AIP, AlAs, AlSb, InN, InP, InAs, InSb, and a mixture thereof; a three-element compound selected from GaNP, GaNAs, GaNSb, GaPAs, GaPSb, AINP, AINAs, AINSb, AlPAs, AlPSb, InGaP, InNP, InNAs, InNSb, InPAs, InZnP, InPSb, and a mixture thereof; and a four-element compound selected from GaAINP, GaAINAs, GaAINSb, GaAIPAs, GaAlPSb, GaInNP, GaInNAs, GaInNSb, GaInPAs, GaInPSb, InAINP, InAINAs, InAINSb, InAIPAs, InAIPSb, InZnP, and a mixture thereof. The group III-V compound may further include a group II metal (for example, InZnP).

The group IV-VI compound may be selected from a two-element compound selected from SnS, SnSe, SnTe, PbS, PbSe, PbTe, and a mixture thereof; a three-element compound selected from SnSeS, SnSeTe, SnSTe, PbSeS, PbSeTe, PbSTe, SnPbS, SnPbSe, SnPbTe, and a mixture thereof; and a four-element compound selected from SnPbSSe, SnPbSeTe, SnPbSTe, and a mixture thereof.

The group IV element or compound may be selected from a single-element compound selected from Si, Ge, and a combination thereof, and a two-element compound selected from SiC, SiGe, and a combination thereof, but is not limited thereto.

The group I-III-VI compound includes, for example, CuInSe₂, CuInS₂, CuInGaSe, and CuInGaS, but is not limited thereto. The group I-II-IV-VI compound includes, for example, CuZnSnSe and CuZnSnS, but is not limited thereto. The group IV element or compound may be selected from a single-element selected from Si, Ge, and a mixture thereof, and a two-element compound selected from SiC, SiGe, and a mixture thereof.

The group II-III-VI compounds may be selected from ZnGaS, ZnAIS, ZnlnS, ZnGaSe, ZnAISe, ZnlnSe, ZnGaTe, ZnAITe, ZnlnTe, ZnGaO, ZnAlO, ZnlnO, HgGaS, HgAIS, HglnS, HgGaSe, HgAISe, HglnSe, HgGaTe, HgAITe, HglnTe, MgGaS, MgAIS, MglnS, MgGaSe, MgAlSe, MglnSe, and a combination thereof, but is not limited thereto.

The group I-II-IV-VI compound may be selected from CuZnSnSe and CuZnSnS, but is not limited thereto.

According to some embodiments, the quantum dot may not include cadmium. The quantum dot may include a semiconductor nanocrystal based on group III-V compounds including indium and phosphorus. The group III-V compound may further include zinc. The quantum dot may include a semiconductor nanocrystal based on a group II-VI compound including a chalcogen element (for example, sulfur, selenium, tellurium, or a combination thereof) and zinc.

In the quantum dot, the two-element compound, the three-element compound, and/or the four-element compound, which are described above, may be present in particles at uniform concentrations, or they may be divided into states having partially different concentrations to be present in the same particle, respectively. In addition, a core/shell structure in which some quantum dots enclose some other quantum dots may be possible. An interface between the core and the shell may have a concentration gradient in which a concentration of elements of the shell decreases closer to its center.

In some embodiments, the quantum dot may have a core-shell structure that includes a core including the nanocrystal described above and a shell surrounding the core. The shell of the quantum dot may serve as a passivation layer for maintaining a semiconductor characteristic and/or as a charging layer for applying an electrophoretic characteristic to the quantum dot by preventing or reducing chemical denaturation of the core. The shell may be a single layer or a multilayer. An interface between the core and the shell may have a concentration gradient in which a concentration of elements of the shell decreases closer to its center. An example of the shell of the quantum dot includes a metal or nonmetal oxide, a semiconductor compound, or a combination thereof.

For example, the metal or non-metal oxide may be a two-element compound such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and the like, or a three-element compound such as MgAl₂O₄, CoFe₂O₄, NiFe₂O₄, CoMn₂O₄, and the like, but embodiments according to the present invention are not limited thereto.

In addition, the semiconductor compound may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AIP, AlSb, or the like, but embodiments according to the present invention are not limited thereto.

An interface between the core and the shell may have a concentration gradient in which a concentration of elements of the shell decreases closer to its center. In addition, the semiconductor nanocrystal may have a structure including one semiconductor nanocrystal core and a multi-layered shell surrounding the semiconductor nanocrystal core. According to some embodiments, the multi-layered shell may have two or more layers, for example, two, three, four, five, or more layers. Two adjacent layers of the shell may have a single composition or different compositions. In the multi-layered shell, each layer may have a composition that varies along a radius.

The quantum dot may have a full width at half maximum (FWHM) of the light emitting wavelength spectrum that is equal to or less than about 45 nm, preferably equal to or less than about 40 nm, and more preferably equal to or less than about 30 nm, and in this range, color purity or color reproducibility may be improved. In addition, since light emitted through the quantum dot is emitted in all directions, a viewing angle of light may be improved.

In the quantum dot, the shell material and the core material may have different energy bandgaps. For example, the energy bandgap of the shell material may be greater than that of the core material. According to some embodiments, the energy bandgap of the shell material may be smaller than that of the core material. The quantum dot may have a multi-layered shell. In the multi-layered shell, an energy bandgap of an outer layer thereof may be larger than that of an inner layer thereof (that is, a layer closer to the core). In the multi-layered shell, the energy bandgap of the outer layer may be smaller than the energy bandgap of the inner layer.

The quantum dot may adjust an absorption/emission wavelength by adjusting a composition and size thereof. The maximum emission peak wavelength of the quantum dot may have a wavelength range from ultraviolet to infrared wavelengths or more.

The quantum dot may include an organic ligand (for example, having a hydrophobic moiety and/or a hydrophilic moiety). The organic ligand moiety may be bound to a surface of the quantum dot. The organic ligand may include RCOOH, RNH₂, R₂NH, R₃N, RSH, R₃PO, R₃P, ROH, RCOOR, RPO(OH)₂, RHPOOH, R₂POOH, or a combination thereof, wherein, R is independently a C3 to C40 substituted or unsubstituted aliphatic hydrocarbon group such as a C3 to C40 (for example, C5 or greater and C24 or less) substituted or unsubstituted alkyl, or a substituted or unsubstituted alkenyl, a C6 to C40 (for example, C6 or greater and C20 or less) substituted or unsubstituted aromatic hydrocarbon group such as a substituted or unsubstituted C6 to C40 aryl group, or a combination thereof.

Examples of the organic ligand may be a thiol compound such as methane thiol, ethane thiol, propane thiol, butane thiol, pentane thiol, hexane thiol, octane thiol, dodecane thiol, hexadecane thiol, octadecane thiol, or benzyl thiol; amine such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, or trioctylamine; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, or benzoic acid; a phosphine compound such as methyl phosphine, ethyl phosphine, propyl phosphine, butyl phosphine, pentyl phosphine, octylphosphine, dioctyl phosphine, tributylphosphine, or trioctylphosphine; a phosphine compound or an oxide compound thereof such methyl phosphine oxide, ethyl phosphine oxide, propyl phosphine oxide, butyl phosphine oxide pentyl phosphine oxide, tributyl phosphine oxide, octyl phosphine oxide, dioctyl phosphine oxide, or trioctyl phosphine oxide; a diphenyl phosphine, triphenyl phosphine compound, or an oxide compound thereof; a C5 to C20 alkyl phosphonic acid such as hexylphosphinic acid, octylphosphinic acid, dodecanephosphinic acid, tetradecanephosphinic acid, hexadecanephosphinic acid, octadecanephosphinic acid; and the like, but are not limited thereto. The quantum dot may include a hydrophobic organic ligand alone or in a mixture of at least one type. The hydrophobic organic ligand may not include a photopolymerizable moiety (for example, an acrylate group, a methacrylate group, etc.).

A second insulating layer P2 may be located on the first color conversion layer CCL1, the second color conversion layer CCL2, and the transmission layer CCL3. The second insulating layer P2 covers and protects the first color conversion layer CCL1, the second color conversion layer CCL2, and the transmission layer CCL3, so that it is possible to prevent or reduce instances of foreign particles flowing into the first color conversion layer CCL1, the second color conversion layer CCL2, and the transmission layer CCL3.

The second insulating layer P2 may further include a low refractive index layer. The low refractive index layer may have a refractive index of about 1.1 to 1.3. The low refractive index layer may include any organic or inorganic material satisfying the refractive index described above.

A first color filter CF1, a second color filter CF2, and a third color filter CF3 may be located on the second insulating layer P2.

The first color filter CF1 may transmit red light that has passed through the first color conversion layer CCL1, and may absorb light of the remaining wavelength, thereby increasing purity of red light emitted to the outside of the display device. The second color filter CF2 may transmit green light that has passed through the second color conversion layer CCL2, and may absorb light of the remaining wavelength, thereby increasing purity of green light emitted to the outside of the display device. The third color filter CF3 may transmit blue light that has passed through the transmission layer CCL3, and may absorb light of the remaining wavelength, thereby increasing purity of blue light emitted to the outside of the display device.

A second light blocking layer BM2 may be located between the first color filter CF1, the second color filter CF2, and the third color filter CF3. The second light blocking layer BM2 may have a shape in which at least two or more of the first color filter CF1, the second color filter CF2, and the third color filter CF3 overlap.

### [Stacked structure of light emitting device]

The light emitting device according to some embodiments in which the first electrode having an ITO/Ag/ITO stacked structure, the first light emitting unit, the first charge generating layer, the second light emitting unit, the second charge generating layer, the third light emitting unit, the third charge generating layer, the fourth light emitting unit, Yb having a thickness of 10 angstroms, the second electrode including AgMg having a thickness of 100 angstroms; and the capping layer having a thickness of 700 angstroms were sequentially stacked, was manufactured.

The first light emitting unit may include the hole injection layer including HAT-CN having a thickness of 50 angstroms, the hole transport layer including NPB having a thickness of 600 angstroms, and m-MTDTA having a thickness of 50 angstroms, the blue light emitting layer, the hole blocking layer including T2T having a thickness of 50 angstroms, and the electron transport layer including TPM-TAZ having a thickness of 200 angstroms and Liq.

The first charge generating layer may include the (1-n)-th type of charge generating layer doped with Li or Yb in CBP(4,4'-bis(N-carbazolyl)-1,1'-biphenyl), and the (1-p)-th type of charge generating layer including the same material as the hole transport layer having a thickness of 50 angstrom and NDP-9.

The second light emitting unit may include the hole transport layer including m-MTDTA having a thickness of 50 angstroms, the blue light emitting layer, the hole blocking layer including T2T having a thickness of 50 angstroms, and the electron transport layer including TPM-TAZ having a thickness of 200 angstroms and Liq.

The second charge generating layer may include the (2-n)-th type of charge generating layer doped with Li or Yb in CBP(4,4'-bis(N-carbazolyl)-1,1'-biphenyl), and the (2-p)-th type of charge generating layer including the same material as the hole transport layer having a thickness of 50 angstroms and NDP-9.

The third light emitting unit may include the hole transport layer including NPB having a thickness of 600 angstroms, the blue light emitting layer, the hole blocking layer including T2T having a thickness of 50 angstroms, and the electron transport layer including TPM-TAZ having a thickness of 200 angstroms and Liq.

The third charge generating layer may include the (3-n)-th type of charge generating layer doped with Li or Yb in CBP(4,4'-bis(N-carbazolyl)-1,1'-biphenyl), and the (3-p)-th type of charge generating layer including the same material as the hole transport layer having a thickness of 50 angstrom and NDP-9.

The fourth light emitting unit may include the hole injection layer including HAT-CN having a thickness of 50 angstroms, the hole transport layer including NPB having a thickness of 600 angstroms and TCTA having a thickness of 50 angstroms, the green light emitting layer, and the hole transport layer including TPM-TAZ having a thickness of 300 angstroms and Liq.

Materials used to form respective layers are as follows.

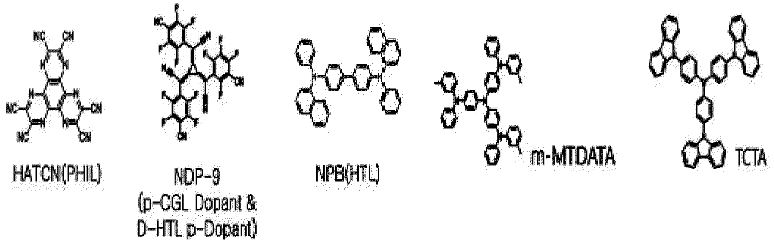

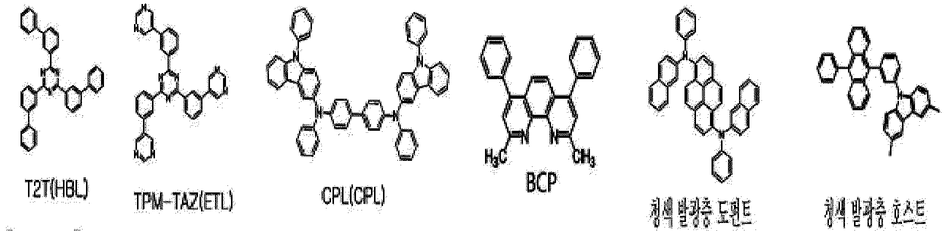

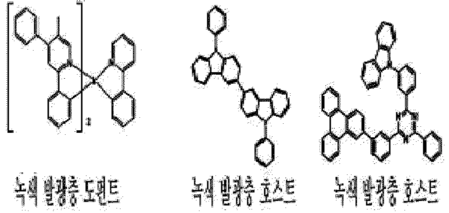

Comparative Example 1 and Comparative Example 2, and Example 1 to Example 6, differ only in the dopant of the (1-n)-th type of charge generating layer, the (2-n)-th type of charge generating layer, and the (3-n)-th type of charge generating layer as follows, and the other configurations are the same as described above.

**(Table 1)**

| Structure | Charge generating layer | | |
|---|---|---|---|
| | (1-n)-th type of charge generating layer dopant | (2-n)-th type of charge generating layer dopant | (3-n)-th type of charge generating layer dopant |
| Comparat ive Example 1 | Li | Li | Li |
| Comparat ive Example 2 | Yb | Yb | Yb |
| Example 1 | Yb | Li | Li |
| Example 2 | Li | Yb | Li |
| Example 3 | Li | Li | Yb |
| Example 4 | Yb | Yb | Li |
| Example 5 | Yb | Li | Yb |
| Example 6 | Li | Yb | Yb |

For the light emitting devices according to Comparative Example 1, Comparative Example 2, and Example 1 to Example 6, the specific resistance, n-CGL total absorption, W efficiency measured at 200 nit luminance, and BT2020 are shown in Table 2.

**(Table 2)**

| | Specific resistance (ρ, Ω·m) | N-CGL total absorption (@500 nm) | W efficiency (Cd/A) | BT2020 (color matching ratio %) |
|---|---|---|---|---|
| Comparative Example 1 | 100 % | 3% | 100 % | 87.8 |
| Comparative Example 2 | 809 % | 12.1% | 98 % | 91.1 |
| Example 1 | 559 % | 5.3 % | 110 % | 91.1 |
| Example 2 | 479 % | 5.4 % | 107 % | 90.3 |
| Example 3 | 360 % | 5.4 % | 105 % | 89.6 |
| Example 4 | 719 % | 8.2 % | 103 % | 90.4 |
| Example 5 | 749 % | 8.4 % | 102 % | 90.0 |
| Example 6 | 689 % | 8.3 % | 102 % | 90.1 |

Referring to Table 2, it can be seen that Examples 1 to 6 are all improved in the specific resistance, n-CGL total absorption, W efficiency, and color matching rate according to BT2020 compared with Comparative Example 1. On the other hand, with Comparative Example 2 compared with Comparative Example 1, most of the characteristics thereof may be improved, but the W efficiency thereof may be reduced. Accordingly, the light emitting device having a range in which all characteristics were improved may have at least one of the plurality of n-type charge generating layers including Li at at least one thereof including Yb.

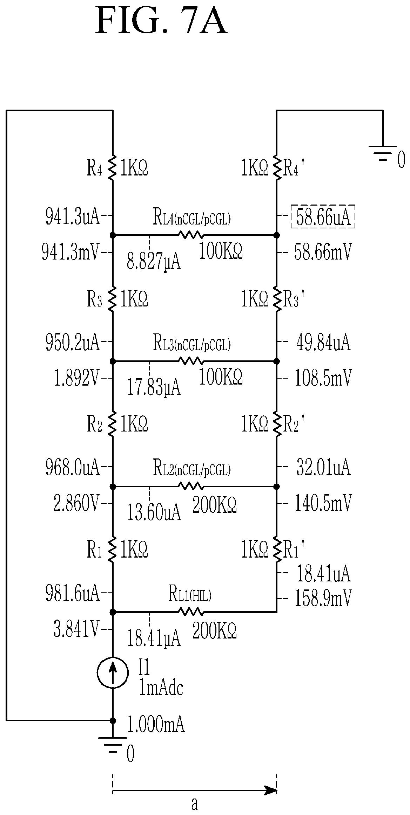

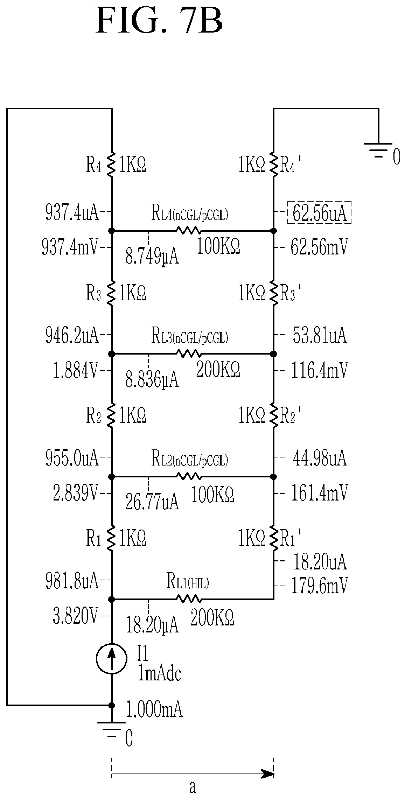

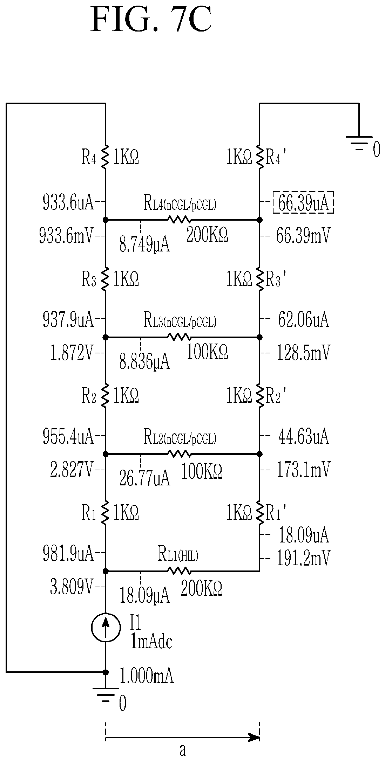

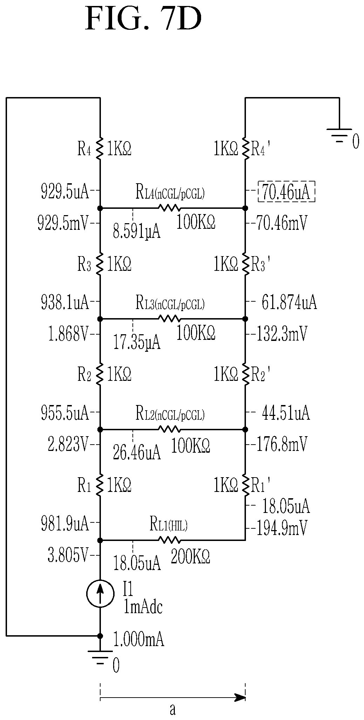

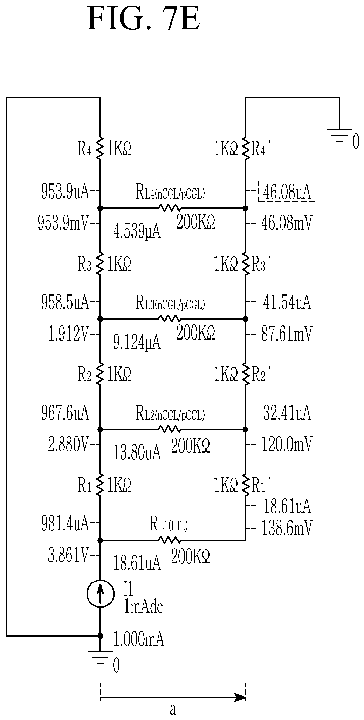

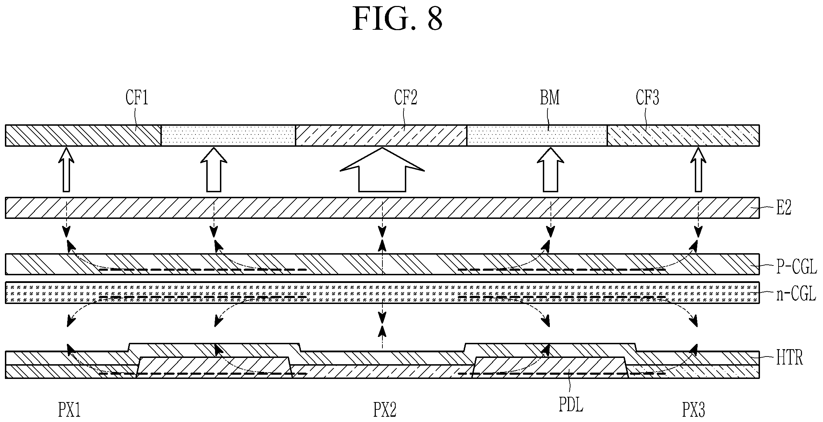

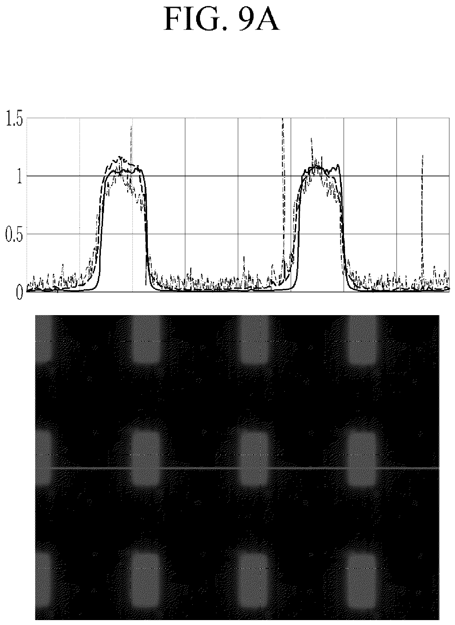

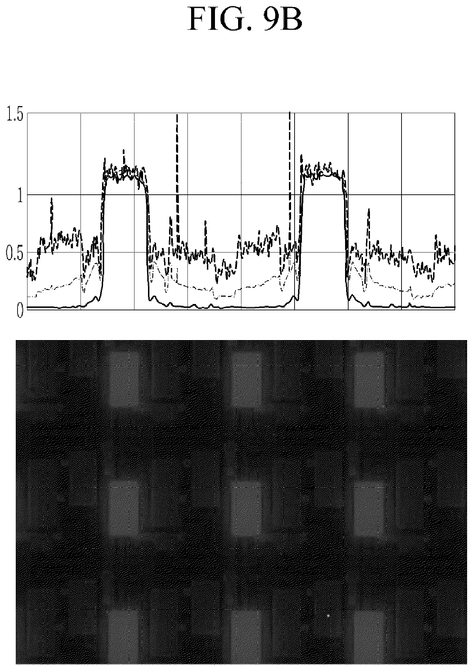

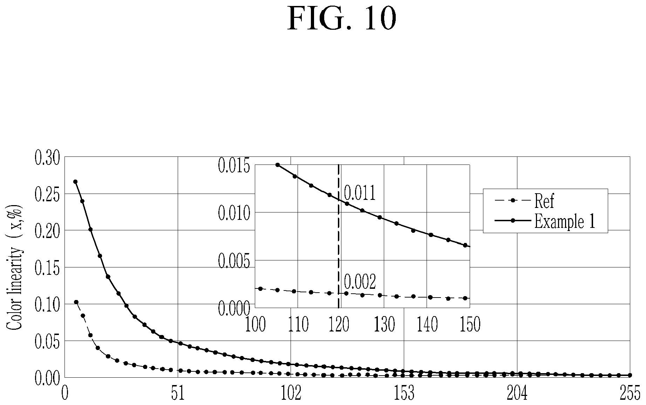

Hereinafter, examples and comparative examples will be described with reference to FIG. 7A to FIG. 10. FIG. 7A, FIG. 7B, and FIG. 7C illustrate circuit diagrams associated with leakage current for Example 1, Example 2, and Example 3, respectively, and FIG. 7D and FIG. 7E illustrate circuit diagrams associated with leakage current for Comparative Example 1 and Comparative Example 2, respectively; FIG. 8 illustrates a schematic view of a leakage current of a display panel according to some embodiments; FIG. 9A illustrates a light emitting image according to some embodiments, and FIG. 9B illustrates a light emitting image according to a comparative example; and FIG. 10 illustrates a graph of a color displacement characteristic according to a gray.

FIG. 7A to FIG. 7E illustrate leakage currents flowing in the light emitting devices of Examples 1 to 3 and Comparative Examples 1 and 2, which are positioned at a distance "a" from a normally lit pixel.

Referring to FIG. 7A, FIG. 7B, and FIG. 7C, according to FIG. 7A, when the (1-n)-th type of charge generating layer is doped with Yb as in Example 1, the resistance (R_{L2}) of the (1-n)-th type of charge generating layer may be 200 KΩ, and the leakage current flowing through the fourth light emitting unit may be 58.66 µA. According to FIG. 7B, when the (2-n)-th type of charge generating layer is doped with Yb as in Example 2, the resistance (R_{L3}) of the (2-n)-th type of charge generating layer may be 200 KΩ, and the leakage current flowing through the fourth light emitting unit may be 62.56 µA. According to FIG. 7C, when the (3-n)-th type of charge generating layer is doped with Yb as in Example 3, the resistance (R_{L4}) of the (3-n)-th type of charge generating layer may be 200 KΩ, and the leakage current flowing through the fourth light emitting unit may be 66.39 µA. Meanwhile, according to FIG. 7D, when all of the n-type charge generating layers are doped with Li as in Comparative Example 1, the resistance of all of the n-type charge generating layers may be 100 KΩ, and in this case, the leakage current flowing through the fourth light emitting unit may be 70.46 µA. According to FIG. 7E, when all of the n-type charge generating layers are doped with Yb as in Comparative Example 2, the resistance of all of the n-type charge generating layers may be 200 KΩ, and the leakage current flowing through the fourth light emitting unit may be 46.08 µA.

Summarizing FIG. 7A to FIG. 7E, in the embodiments in which at least one of the plurality of n-type charge generating layers includes Li and at least one of the remaining n-type charge generating layers includes Yb, the leakage current in the adjacent pixel may be reduced. It can be seen that the leakage current is most reduced when all of the plurality of n-type charge generating layers are doped with Yb. However, in this case, as shown in Table 2 above, in Comparative Example 2, although the leakage current is controlled, because light efficiency may be reduced, it can be seen that it is not suitable for a display device.

Considering the result values in Table 2 and FIG. 7A, it can be seen that Example 1 in which the W efficiency and color matching rate are improved, and in order to effectively lower the lateral leakage current value, the (1-n)-th type of charge generating layer includes Yb and the (3-n)-th type of charge generating layer includes Li may be used according to some embodiments.

Referring to FIG. 8, when a voltage for light emitting is applied to one pixel PX2, a current may flow into adjacent pixels PX1 and PX2 along the hole transport region HTR and the charge generating layers n-CGL and p-CGL (a path of the current is indicated by an arrow). According to some embodiments, this is referred to as a lateral current leakage. Accordingly, due to the current leaking from the lateral surface of one pixel PX2, unintentional light emission may occur in the pixels PX1 and PX3 adjacent to the pixel PX2. Accordingly, color mixing may occur, or a characteristic of a color emitted due to light loss may be deteriorated.

It can be seen that when the leakage current for the adjacent pixel is suppressed according to the example as shown in the graph of FIG. 9A, unintended light emission from the adjacent pixel is suppressed as shown in the image of FIG. 9A. On the other hand, referring to FIG. 9B, in the case of the comparative example, the leakage current is confirmed in the adjacent pixel as shown in the graph of FIG. 9B, and accordingly, it can be seen that light emission occurs in the adjacent pixel as shown in the image of FIG. 9B.

Referring to FIG. 10, a color displacement characteristic (color linearity) for each gray is illustrated for Example 1. In the case of Example 1, it was confirmed that a color displacement characteristic similar to that of "Ref" was exhibited and thus the display quality was improved.

In the display device including the light emitting device in which the plurality of light emitting units are stacked, there may be a problem that unnecessary pixels are turned on due to leakage current generated between adjacent pixels. A pixel that is unnecessarily turned on may be referred to as parasitic lighting. The light emitting device according to some embodiments may have a relatively high resistance and may block leakage current as some n-type charge generating layers are doped with lanthanum metal. Accordingly, the parasitic lighting may be prevented or reduced, so that the display quality such as the color area characteristic and color linearity of the display device may be relatively improved.

While this invention has been described in connection with what is presently considered to be practical embodiments, it is to be understood that the invention is not limited to the disclosed embodiments, but, on the contrary, is intended to cover various modifications and equivalent arrangements included within the spirit and scope of the appended claims, and their equivalents.

### Description of Some of the Reference Symbols

E1: first electrode
E2: second electrode
EL1, EL2, EL3, EL4: light emitting unit
CGL: charge generating layer
n-CGL1, n-CGL2, n-CGL3: n-type charge generating layer
p-CGL1, p-CGL2, p-CGL3: p-type charge generating layer

## Claims

1. A light emitting device comprising:
a first electrode;
a second electrode overlapping the first electrode;
m light emitting units between the first electrode and the second electrode; and
m-1 charge generating layers between adjacent light emitting units,
wherein the charge generating layer includes: an n-type charge generating layer and a p-type charge generating layer;
at least one of a plurality of n-type charge generating layers includes a dopant including an alkali metal, and at least one of a plurality of n-type charge generating layers includes a dopant including a lanthanum metal;
contents of the alkali metal and the lanthanum metal doped in the n-type charge generating layer are different from each other; and
the m is a natural number of greater than or equal to 3.

2. The light emitting device of claim 1, wherein
the alkali metal doped in the n-type charge generating layer is included in an amount of 0.1 to 3 vol%, and the lanthanum metal doped in the n-type charge generating layer is included in an amount of 1 to 10 vol%.

3. The light emitting device of claim 1 or claim 2, wherein
at least one of the m light emitting units emits blue light, and at least one of the remaining light emitting units emits green light.

4. The light emitting device of any one of claims 1 to 3, wherein
m is 4;
the light emitting device includes a first light emitting unit, a second light emitting unit, a third light emitting unit, and a fourth light emitting unit; and
the charge generating layer includes a first charge generating layer, a second charge generating layer, and a third charge generating layer,
wherein the first charge generating layer includes a (1-n)-th type of charge generating layer, the second charge generating layer includes a (2-n)-th type of charge generating layer, and the third charge generating layer includes a (3-n)-th type of charge generating layer.

5. The light emitting device of claim 4, wherein
at least one of the (1-n)-th type of charge generating layer, the (2-n)-th type of charge generating layer, or the (3-n)-th type of charge generating layer is doped with a dopant including an alkali metal, and at least one of the remaining charge generating layers is doped with a dopant including a lanthanum metal.

6. The light emitting device of claim 5, wherein
one of the (1-n)-th type of charge generating layer, the (2-n)-th type of charge generating layer, and the (3-n)-th type of charge generating layer is doped with a dopant including a lanthanum metal, and the remainder thereof are doped with a dopant including an alkali metal.

7. The light emitting device of claim 5, wherein
two of the (1-n)-th type of charge generating layer, the (2-n)-th type of charge generating layer, and the (3-n)-th type of charge generating layer are doped with a dopant including a lanthanum metal, and the remainder thereof is doped with a dopant including an alkali metal.

8. The light emitting device of claim 1, wherein
the n-type charge generating layer includes a host, and
the host includes one of compounds represented by Chemical Formula 1, Chemical Formula 2 and Chemical Formula 2': 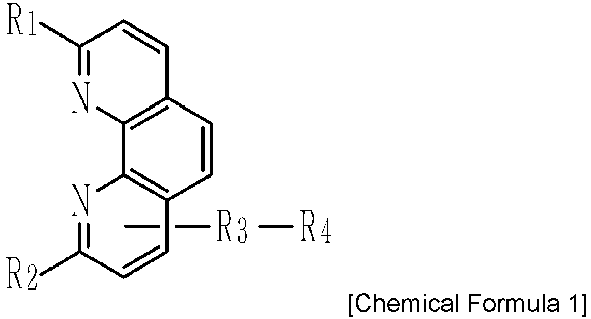 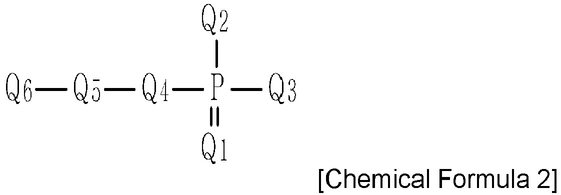 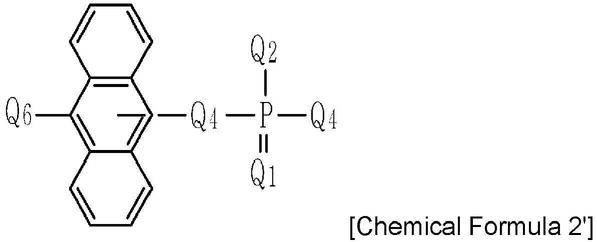
In Chemical Formula 1,
each of R1, R2, R3, R4, R5, and R6 independently includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, a substituted or unsubstituted heteroaryl group having 2 or more to 30 or less ring-formed carbon atoms, a substituted or unsubstituted phenanthroline group 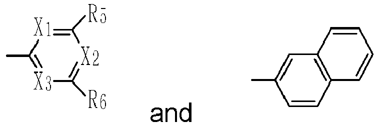 ; and
each of X1, X2, and X3 independently includes one of a carbon atom, a nitrogen atom, and an oxygen atom,
In Chemical Formula 2 and Chemical Formula 2',
Q1 includes one of an oxygen atom and a sulfur atom;
each of Q2, Q3, Q4, and Q5 independently includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, and a substituted or unsubstituted heteroaryl group having 2 or more to 30 or less ring-formed carbon atoms;
Q6 independently includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, and a substituted or unsubstituted heteroaryl group having 2 or more to 30 or less ring-formed carbon atoms, , 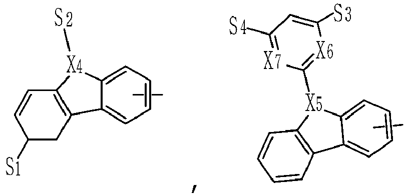 , and 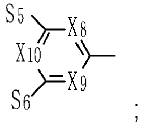
S1 includes at least one of a CN, a hydrogen atom, a deuterium atom, a halogen atom, a substituted or unsubstituted amino group, a substituted or unsubstituted oxy group, a substituted or unsubstituted thio group, and a substituted or unsubstituted alkyl group having 1 or more to 20 or less carbon atoms;
S2, S3, S4, S5, or S6 includes one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 or more to 20 or less carbon atoms, a substituted or unsubstituted aryl group having 6 or more and 30 or less ring-formed carbon atoms, and a substituted or unsubstituted heteroaryl group having 2 or more to 30 or less ring-formed carbon atoms; and
each of X4, X5, X6, X7, X8, X9, and X10 independently includes one of a carbon atom, a nitrogen atom, and an oxygen atom.

9. The light emitting device of claim 8, wherein
the n-type charge generating layer includes one of compounds represented by Chemical Formula 1-A and Chemical Formula 2-A, and
in Chemical Formula 1-A and Chemical Formula 2-A, M is the dopant and forms a complex with the host: 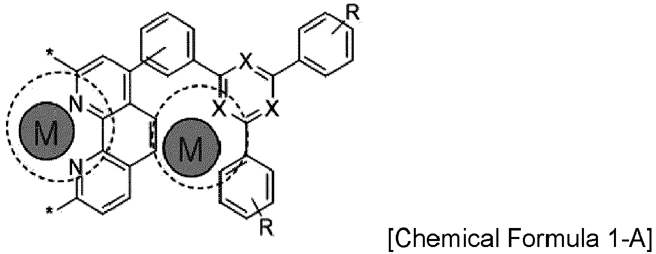 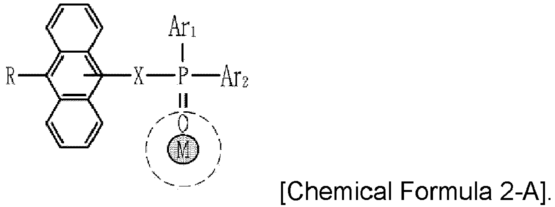
In Chemical Formula 1-A,
X is C or N,
R is one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-formed carbon atoms, a substituted or unsubstituted heteroaryl group having 2 to 30 ring-formed carbon atoms, containing a substituted or unsubstituted phenanthroline group, and
* means that any functional group can be linked,
in chemical Formula 2-A,
X, Ar₁ and Ar₂ are each one or more of a single bond, a hydrogen atom, a deuterium atom, a halogen atom, a substituted or unsubstituted amino group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-formed carbon atoms, and a substituted or unsubstituted heteroaryl group having 2 to 30 ring-formed carbon atoms.

10. A display device comprising:
a substrate;
a transistor on the substrate; and
a light emitting device electrically connected to the transistor,
wherein the light emitting device includes:
a first electrode;
a second electrode overlapping the first electrode;
m light emitting units between the first electrode and the second electrode; and
m-1 charge generating layers between adjacent light emitting units, and
the charge generating layer includes an n-type charge generating layer;
at least one of a plurality of n-type charge generating layers includes a dopant including an alkali metal, and at least one of a plurality of n-type charge generating layers includes a dopant including a lanthanum metal; and
the m is a natural number of greater than or equal to 3.

11. The display device of claim 10, further comprising
a color conversion part on the light emitting device,
wherein the color conversion part includes a first color conversion layer, a second color conversion layer, and a transmission layer that include quantum dots.

12. The display device of claim 10 or claim 11, wherein
the alkali metal doped in the n-type charge generating layer is included in an amount of 0.1 to 3 vol%, and the lanthanum metal doped in the n-type charge generating layer is included in an amount of 1 to 10 vol%.

13. The display device of any one of claims 10 to 12, wherein
the m is 4;
the light emitting device includes a first light emitting unit, a second light emitting unit, a third light emitting unit, and a fourth light emitting unit;
the charge generating layer includes a first charge generating layer, a second charge generating layer, and a third charge generating layer; and
the first charge generating layer includes a (1-n)-th type of charge generating layer, the second charge generating layer includes a (2-n)-th type of charge generating layer, and the third charge generating layer includes a (3-n)-th type of charge generating layer,
wherein one of the (1-n)-th type of charge generating layer, the (2-n)-th type of charge generating layer, and the (3-n)-th type of charge generating layer is doped with a dopant including a lanthanum metal, and the remainder thereof are doped with a dopant including an alkali metal.

14. The display device of claim 13, wherein
two of the (1-n)-th type of charge generating layer, the (2-n)-th type of charge generating layer, and the (3-n)-th type of charge generating layer are doped with a dopant including a lanthanum metal, and the remainder thereof is doped with a dopant including an alkali metal.

15. The display device of any one of claims 10 to 14, wherein
the alkali metal is lithium, and the lanthanum metal is ytterbium.
